(19) **Europäisches Patentamt / European Patent Office / Office européen des brevets**

(11) **EP 4 560 334 A1**

(12) **EUROPEAN PATENT APPLICATION**
published in accordance with Art. 153(4) EPC

(43) Date of publication:
**28.05.2025   Bulletin 2025/22**

(21) Application number: **23939208.7**

(22) Date of filing: **26.09.2023**

(51) International Patent Classification (IPC):
***G01R 31/389*** (2019.01)

(52) Cooperative Patent Classification (CPC):
**Y02E 60/10**

(86) International application number:
**PCT/CN2023/121339**

(87) International publication number:
**WO 2024/244234 (05.12.2024 Gazette 2024/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:   **30.05.2023   CN 202310628914**

(71) Applicant: **Deepal Automobile Technology Co., Ltd.**
**Chongqing 401133 (CN)**

(72) Inventors:
• **LI, Dongjiang**
  **Chongqing 401135 (CN)**
• **LI, Zonghua**
  **Chongqing 401135 (CN)**
• **YU, Cheng**
  **Chongqing 401135 (CN)**
• **YANG, Xu**
  **Chongqing 401135 (CN)**

(74) Representative: **2K Patentanwälte Blasberg Kewitz & Reichel**
**Partnerschaft mbB**
**Schumannstrasse 27**
**60325 Frankfurt am Main (DE)**

(54) **LITHIUM ION BATTERY INTERNAL RESISTANCE CALCULATION METHOD AND APPARATUS, ELECTRONIC DEVICE AND STORAGE MEDIUM**

(57)      A lithium ion battery internal resistance calculation method and apparatus, an electronic device, and a storage medium. The lithium ion battery internal resistance calculation method comprises: dividing a battery internal resistance to be calculated into a charge transfer internal resistance, a mass transfer internal resistance and an ohmic internal resistance (S120). Functional relationships between each internal resistance and factors such as the temperature, a state of charge of a battery, and charge and discharge currents are established. When calculating the internal resistance of each part, the method of establishing the function relationships by mathematical fitting is used, and the effect of the temperature, the state of charge of the battery and the charge and discharge currents on the battery internal resistance is also taken into account, so that the battery internal resistance can be predicted more accurately. Moreover, according to the method, the change rule of the internal resistance of the battery throughout the life cycle thereof is predicated by establishing functional relationships between internal resistances and different aging conditions of the battery, thereby reducing the prediction error of the battery internal resistance in practical application.

| | |
|---|---|
| Obtain battery working parameters | S110 |
| Decompose an internal resistance of a to-be-calculated battery into a charge transfer internal resistance, a mass transfer internal resistance, and an ohmic internal resistance | S120 |
| Calculate the charge transfer internal resistance based on a temperature and a charging/discharging current, calculate the mass transfer internal resistance based on a first function between a lithium-ion concentration and a time, the charging/discharging current, and a concentration difference potential, and calculate the ohmic internal resistance based on a function between a state of charge of a lithium-ion battery and a temperature and an ohmic internal resistance | S130 |
| Combine the mass transfer internal resistance, the charge transfer internal resistance, and the ohmic internal resistance to obtain the internal resistance of the to-be-calculated battery | S140 |

FIG. 1

**Description**

TECHNICAL FIELD

The present invention relates to the field of battery management systems for electric vehicles, and in particular, to a lithium ion battery internal resistance calculation method and apparatus, electronic device, and a storage medium.

BACKGROUND

An internal resistance of a lithium-ion battery is one of the most important characteristic parameters of the battery. It directly affects the overpotential of the battery, and affects charging performance, discharge performance, and safety performance of the battery. For example, an excessive internal resistance causes an increase in a charging voltage plateau and a decrease in a discharge voltage plateau, thereby greatly reducing battery use efficiency. The excessive internal resistance also causes a discharge voltage to trigger a cutoff voltage more easily, thereby affecting discharge power of the battery and user driving experience. More importantly, the excessive internal resistance can result in increased heat generation during battery use, accelerating temperature rise and exacerbating the temperature inconsistency within the battery pack, which poses safety risks. Therefore, accurately obtaining a battery internal resistance is essential for more accurate battery management and safer battery use.

The internal resistance is a very complicated parameter. It is not only affected by the battery manufacturing process, but also varies with the use condition or battery state of charge. This makes a method for obtaining an internal resistance very difficult. At present, the industry obtains an internal resistance through an experimental testing method. For example, the solutions of CN111999667A describe a method for obtaining an internal resistance at different temperatures through experimental tests. In this method, internal resistances at different temperatures are first obtained, and then a mathematical relationship between an internal resistance and a temperature is obtained through data fitting. Resistance values at different temperatures may be calculated by using the mathematical relationship. Using experimental methods to obtain an internal resistance is relatively straightforward; however, to obtain an accurate internal resistance, it is necessary to design a highly complex matrix of testing conditions that encompasses various states of charge (SOC) of the battery, environmental temperatures, and operational conditions. The solutions of CN113109726Adescribe a method for calculating an internal resistance of a battery by using an internal resistance model. In this method, an internal resistance is first calculated by using an equivalent circuit model, and based on the calculated internal resistance, a function between the internal resistance and a temperature, an SOC, and a discharge current is established by using a quadratic polynomial function, a cubic spline fitting function, and the like. Finally, an internal resistance of a battery is quickly calculated based on the foregoing function. Although this method takes into account the effects of temperature, state of charge (SOC), and discharge current on the internal resistance, it relies solely on mathematical fitting to establish the function between internal resistance and these factors. The fitting results obtained through this approach do not generalize well to conditions outside of the experimental setup, and it fails to consider the variations in internal resistance throughout the entire lifecycle of the battery. Consequently, significant deviations are likely to arise in practical applications.

SUMMARY

In view of the foregoing disadvantages of the prior art, the present invention provides a method and an apparatus for calculating an internal resistance of a lithium-ion battery, an electronic device, and a storage medium, so as to resolve the foregoing technical problems.

The present invention provides a method for calculating an internal resistance of a lithium-ion battery, where the method for calculating an internal resistance of a lithium-ion battery includes: obtaining battery working parameters, where the battery working parameters include a temperature, a charging/discharging current, a concentration difference potential, a function between a lithium-ion concentration and a time, and a function between an ohmic internal resistance and aging of a lithium-ion battery; decomposing an internal resistance of a to-be-calculated battery into a charge transfer internal resistance, a mass transfer internal resistance, and an ohmic internal resistance; calculating the charge transfer internal resistance based on the temperature and a charging/discharging current, calculating the mass transfer internal resistance based on a first function between a lithium-ion concentration and a time, the charging/discharging current, and the concentration difference potential, and calculating the ohmic internal resistance based on the function between the state of charge of the lithium-ion battery and the temperature and the ohmic internal resistance; and combining the mass transfer internal resistance, the charge transfer internal resistance, and the ohmic internal resistance to obtain the internal resistance of the to-be-calculated battery.

In an embodiment of the present invention, the calculating the charge transfer internal resistance based on the temperature and the charging/discharging current includes: obtaining the charge transfer internal resistance by using a gas constant, a Faraday constant, the temperature, and the charging/discharging current.

In an embodiment of the present invention, the calculating the mass transfer internal resistance based on the function between a lithium-ion concentration and a time and the concentration difference potential, where the concentration difference potential includes a negative electrode concentration difference potential, a positive electrode concentration difference potential, and an electrolyte concentration difference potential includes: obtaining the negative electrode concentration difference potential by using a temperature and a negative electrode state of charge of the lithium-ion battery; obtaining the positive electrode concentration difference potential by using a temperature and a positive electrode state of charge of the lithium-ion battery; obtaining the negative electrode concentration difference potential by using a quantity of migrated lithium ions, a concentration of lithium ions at an electrolyte layer on a surface of a positive electrode of the battery, a concentration of lithium ions at an electrolyte layer on a surface of a negative electrode of the battery, a temperature, and the function between a lithium-ion concentration and a time; and obtaining the mass transfer internal resistance based on the first function between a lithium-ion concentration and a time, the positive electrode concentration difference potential, the negative electrode concentration difference potential, the electrolyte concentration difference potential, and the charging/discharging current.

In an embodiment of the present invention, the obtaining the negative electrode concentration difference potential by using a gas constant, a Faraday constant, a temperature, and a negative electrode state of charge of the lithium-ion battery includes: obtaining the negative electrode concentration difference potential according to the following formula:

$$\eta_{mt}^{-} = -\frac{RT}{F}\ln\left(\frac{1-x_1}{x_1}\right)$$

Here, $\eta_{mt}^{-}$ is the concentration difference potential in a lithium-ion transmission process at the negative electrode, F is the Faraday constant, R is the gas constant, T is the temperature, and $x_1$ is the positive electrode state of charge.

In an embodiment of the present invention, the obtaining the positive electrode concentration difference potential by using a gas constant, a Faraday constant, a temperature, and a positive electrode state of charge of the lithium-ion battery includes: obtaining the positive electrode concentration difference potential according to the following formula:

$$\eta_{mt}^{+} = -\frac{RT}{F}\ln\left(\frac{1-x_2}{x_2}\right)$$

Here, $\eta_{mt}^{+}$ is the concentration difference potential in a lithium-ion transmission process at the positive electrode, F is the Faraday constant, R is the gas constant, T is the ambient temperature, and $x_2$ is the positive electrode state of charge.

In an embodiment of the present invention, the obtaining the negative electrode concentration difference potential by using a quantity of migrated lithium ions, a concentration of lithium ions at an electrolyte layer on a surface of a positive electrode of the battery, a concentration of lithium ions at an electrolyte layer on a surface of a negative electrode of the battery, a Faraday constant, a gas constant, and a temperature includes: obtaining an initial electrolyte concentration difference potential by using the quantity of migrated lithium ions, the concentration of the lithium ions at the electrolyte layer on the surface of the positive electrode of the battery, the concentration of the lithium ions at the electrolyte layer on the surface of the negative electrode of the battery, the Faraday constant, the gas constant, and the temperature:

$$\eta_{mt}^{e} = \frac{2t_{+}RT}{F}\ln\left(\frac{C_{Li}^{ca}}{C_{Li}^{an}}\right)$$

where $\eta_{mt}^{e}$ is the initial electrolyte concentration difference potential, t is the quantity of migrated lithium ions, $C_{Li}^{ca}$ is the concentration of the lithium ions at the electrolyte layer on the surface of the positive electrode, $C_{Li}^{an}$ is the concentration of the lithium ions at the electrolyte layer on the surface of the negative electrode, F is the Faraday constant, R is the gas constant, and T is the temperature; and obtaining the electrolyte concentration difference potential $\eta_{mt}^{E}$ based on the first function between a lithium-ion concentration and a time and the initial electrolyte concentration difference potential:

$$\eta_{mt}^{E} = f_{e}(T, t_{0})$$

Here, $\eta_{mt}^{E}$ is the electrolyte concentration difference potential, T is the temperature, and $t_{0}$ is a battery aging time.

In an embodiment of the present invention, the obtaining the mass transfer internal resistance based on the first function between a lithium-ion concentration and a time, the positive electrode concentration difference potential, the negative electrode concentration difference potential, the electrolyte concentration difference potential, and the charging/discharging current includes: summing the positive electrode concentration difference potential, the negative electrode concentration difference potential, and the electrolyte concentration difference potential to obtain a first total concentration difference potential; and determining a ratio of the first total concentration difference potential to the charging/discharging current as the mass transfer internal resistance.

In an embodiment of the present invention, the calculating the ohmic internal resistance based on the function between the state of charge of the lithium-ion battery and the temperature and the ohmic internal resistance includes: setting first test parameters, where the first test parameters include the state of charge, the reference ambient temperature, and a preset frequency range of the lithium-ion battery, and there are a plurality of groups of the first test parameters; testing AC impedance under the first test parameters to obtain a plurality of groups of AC impedance test results; recording the AC impedance test results as Nyquist plots to obtain a plurality of Nyquist plots, and obtaining an intercept of a horizontal axis of a high frequency band in the Nyquist plot by using a linear difference method; recording the intercept of the Nyquist plot as an ohmic internal resistance under a corresponding test parameter, to obtain a plurality of reference ohmic internal resistances, and outputting a two-dimensional numerical table of the reference ohmic internal resistances; fitting a reference ohmic internal resistance in the two-dimensional numerical table of the reference ohmic internal resistances based on a function between an ohmic internal resistance and a temperature and a state of charge of a lithium-ion battery, to obtain an ohmic internal resistance fitting coefficient; and substituting the ohmic internal resistance fitting coefficient into the function between an ohmic internal resistance and a temperature and a state of charge of a lithium-ion battery, to obtain an ohmic internal resistance.

In an embodiment of the present invention, the combining the mass transfer internal resistance, the charge transfer internal resistance, and the ohmic internal resistance to obtain the internal resistance of the to-be-calculated battery further includes: calculating a life-cycle mass transfer internal resistance and a life-cycle ohmic internal resistance; and summing the charge transfer internal resistance, the life-cycle mass transfer internal resistance, and the life-cycle ohmic internal resistance to obtain a life-cycle internal resistance of the to-be-calculated battery.

In an embodiment of the present invention, the calculating a life-cycle mass transfer internal resistance includes:

obtaining a life-cycle electrolyte concentration difference potential $\eta_{mt}^{h}$ based on the initial electrolyte concentration difference potential and a second function between a lithium-ion concentration and a time:

$$\eta_{mt}^{h} = f_{e}(T, t_{0}, x, I)$$

where $\eta_{mt}^{h}$ is the life-cycle electrolyte concentration difference potential, $t_{0}$ is the battery aging time, T is the ambient temperature, x is the state of charge of the negative electrode, and I is the charging/discharging current; summing the positive electrode concentration difference potential, the negative electrode concentration difference potential, and the life-cycle electrolyte concentration difference potential to obtain a second total concentration difference potential; and determining a ratio of the second total concentration difference potential to the charging/discharging current as the life-cycle mass transfer internal resistance.

In an embodiment of the present invention, the calculating a life-cycle mass transfer internal resistance includes:

obtaining an initial ohmic internal resistance of the lithium-ion battery by using a function between an ohmic internal resistance and a state of charge of the lithium-ion battery and a temperature; obtaining a function between the ohmic internal resistance and aging of the lithium-ion battery according to the initial ohmic internal resistance and a relationship between a thickness of a solid-state electrolyte membrane and aging of the lithium-ion battery:

$$f_\Omega(t) = R_\Omega^{re}(1 + \beta \ln(1 + \theta t_0))$$

where $R_\Omega^{re}$ represents the initial ohmic internal resistance of the lithium-ion battery in an initial state, $\beta$ and $\theta$ are constants, and $t_0$ is a battery aging time; and obtaining the life-cycle ohmic internal resistance according to the function between an ohmic internal resistance and a state of charge of the lithium-ion battery and an ambient temperature and the function between the ohmic internal resistance and the aging of the lithium-ion battery:

$$R_\Omega^h = R_\Omega^0(1 + ax + bT + cxT)(1 + \beta \ln(1 + \theta t_0))$$

Here, $R_\Omega^h$ is the life-cycle ohmic internal resistance, $R_\Omega^0$ is an ohmic internal resistance at a reference temperature, $T$ is a temperature, $x$ is the state of charge of the battery, $t_0$ is the battery aging time, $a$, $b$, and $c$ are to-be-fitted coefficients, and $\beta$ and $\theta$ are constants.

In an embodiment of the present invention, an apparatus for calculating an internal resistance of a lithium-ion battery is provided, including: an obtaining module, configured to obtain a function between a lithium-ion concentration and a time, and obtain a life-cycle ohmic internal resistance; a decomposition module, configured to decompose an internal resistance of a to-be-calculated battery into a charge transfer internal resistance, a mass transfer internal resistance, and an ohmic internal resistance; a calculation module, configured to: calculate the charge transfer internal resistance based on the temperature and a charging/discharging current, calculate the mass transfer internal resistance based on the function between a lithium-ion concentration and a time, the charging/discharging current, and the concentration difference potential, and calculate the ohmic internal resistance based on the function between a state of charge of the lithium-ion battery and the temperature and the ohmic internal resistance; and a combination module, configured to combine the mass transfer internal resistance, the charge transfer internal resistance, and the ohmic internal resistance to obtain the internal resistance of the to-be-calculated battery.

According to an aspect of the embodiments of the present invention, an electronic device is provided. The electronic device includes: one or more processors; and a storage apparatus, configured to store one or more programs. When the one or more programs are executed by the one or more processors, the electronic device is enabled to implement the method for calculating an internal resistance of a lithium-ion battery in any one of the foregoing embodiments.

According to an aspect of the embodiments of the present invention, a computer-readable storage medium is provided, and a computer program is stored thereon. When the computer program is executed by a processor of a computer, the computer is enabled to execute the method for calculating an internal resistance of a lithium-ion battery in any one of the foregoing embodiments.

Beneficial effects of the present invention are as follows: the present invention provides a method and an apparatus for calculating an internal resistance of a lithium-ion battery, an electronic device, and a storage medium. In the method, an internal resistance of a to-be-calculated battery is decomposed into a charge transfer internal resistance, a mass transfer internal resistance, and an ohmic internal resistance. A function between each internal resistance and a temperature, a battery state of charge, and a charging/discharging current is established. In calculating each internal resistance, not only the mathematical fitting method is used to establish the function, but also the influence of temperature, battery state of charge and charging/discharging current on the lithium-ion battery internal resistance is taken into account, so as to predict the internal resistance of the lithium-ion battery more accurately. In addition, the present invention also predicts the change law of the internal resistance of the battery throughout its life cycle by establishing a function between each internal resistance and different aging conditions of the lithium-ion battery, thereby reducing the prediction error of the internal resistance of the lithium-ion battery in actual application.

It should be understood that the foregoing general descriptions and the following detailed descriptions are merely examples and explanations, and cannot limit this application.

BRIEF DESCRIPTION OF DRAWINGS

The accompanying drawings herein are incorporated in this specification, constitute a part of this specification, show embodiments in accordance with this application, and are used with this specification to explain a principle of this application. Clearly, the accompanying drawings in the following descriptions are merely some embodiments of this application. A person of ordinary skill in the art may still derive other drawings from these accompanying drawings without creative efforts. In the accompanying drawings:

FIG. 1 is a schematic flowchart of a method for calculating an internal resistance of a lithium-ion battery according to an example embodiment of the present invention;

FIG. 2 is a specific flowchart of a method for calculating an internal resistance of a lithium-ion battery according to an example embodiment of the present invention;

FIG. 3 is a current and potential curve of cyclic voltammetry shown in an example embodiment of the present invention;

FIG. 4 is a specific flowchart of a method for calculating an internal resistance of a lithium-ion battery according to an example embodiment of the present invention;

FIG. 5 is a specific flowchart of a method for calculating an internal resistance of a lithium-ion battery according to an example embodiment of the present invention;

FIG. 6 is a specific schematic diagram of a method for calculating an internal resistance of a lithium-ion battery according to an example embodiment of the present invention;

FIG. 7a is a curve graph showing changes of a state of charge and a voltage of an LFP (lithium iron phosphate, $LiFePO_4$) battery under a fast charging condition according to an example embodiment of the present invention;

FIG. 7b is a curve graph showing changes of a state of charge and a current of an LFP (lithium iron phosphate, $LiFePO_4$) battery under a fast charging condition according to an example embodiment of the present invention;

FIG. 7c is a curve graph showing changes of a state of charge and a resistance of an LFP (lithium iron phosphate, $LiFePO_4$) battery under a fast charging condition according to an example embodiment of the present invention;

FIG. 8a is a curve graph showing changes of a state of charge and a voltage of an LFP (lithium iron phosphate, $LiFePO_4$) battery in a travelling condition according to an example embodiment of the present invention;

FIG. 8b is a curve graph showing changes of a state of charge and a current of an LFP (lithium iron phosphate, $LiFePO_4$) battery in a travelling condition according to an example embodiment of the present invention;

FIG. 8c is a curve graph showing changes of a state of charge and a resistance of an LFP (lithium iron phosphate, $LiFePO_4$) battery in a travelling condition according to an example embodiment of the present invention;

FIG. 9a is a curve graph showing changes of a state of charge and a voltage of an NMC (lithium nickel manganese cobalt, $LiNixMnyCozO_2$) battery in a travelling condition according to an example embodiment of the present invention;

FIG. 9b is a curve graph showing changes of a state of charge and a current of an NMC (lithium nickel manganese cobalt, $LiNixMnyCozO_2$) battery in a travelling condition according to an example embodiment of the present invention;

FIG. 9c is a curve graph showing changes of a state of charge and a resistance of an NMC (lithium nickel manganese cobalt, $LiNixMnyCozO_2$) battery in a travelling condition according to an example embodiment of the present invention;

FIG. 10 is an apparatus for calculating an internal resistance of a lithium-ion battery according to an example embodiment of the present invention; and

FIG. 11 is a schematic diagram of a structure of a computer system used to implement an electronic device according to an embodiment of the present invention.

DESCRIPTION OF EMBODIMENTS

The following describes implementations of the present invention with reference to accompanying drawings and preferred embodiments. A person skilled in the art can easily understand other advantages and effects of the present invention based on content disclosed in this specification. The present disclosure may be further implemented or applied by using other different specific implementations. Various details in this specification may also be modified or altered based on different viewpoints and applications without departing from the essence of the present invention. It should be understood that the preferred embodiments are merely intended to describe the present invention, and are not intended to limit the protection scope of the present invention.

It should be noted that the figures provided in the following embodiments merely schematically describe the basic concept of the present invention. Therefore, the figures display only components related to the present invention instead of being drawn based on a quantity, shapes, and sizes of components in actual implementation. Forms, the quantity, and a ratio of the components in actual implementation of the figures may be randomly changed, and a component layout form of the figures may also be more complex.

In the following descriptions, a large quantity of details are discussed to provide a more thorough explanation of the embodiments of the present invention. However, it is clear to a person skilled in the art that the embodiments of the present invention may be implemented without these specific details. In other embodiments, well-known structures and devices are shown in a block diagram rather than in a detail form, to avoid making the embodiments of the present invention difficult to understand.

A lithium-ion battery (Li-ion Batteries) is a secondary battery (rechargeable battery), and works mainly by moving lithium ions between a positive electrode and a negative electrode. A lithium-ion battery is essentially a battery with a difference in concentration. A positive electrode material and a negative electrode material have different electrochemical potentials, and are separated from each other by a diaphragm. Lithium ions (Li+) move from an electrode of an intercalation material with a relatively high chemical potential to an electrode with a relatively low potential. Only the lithium ions can move in an electrolyte through the diaphragm. Charge compensation electrons move only through an external circuit, to form a current for output use. Discharge process: in a fully charged lithium-ion battery, lithium ions are embedded in an anode material. The anode (negative electrode) carbon has a layered structure with many micropores, and the lithium ions are embedded in the micropores of the carbon layer. During discharge, lithium ions (Li+) move from the anode to the cathode through the diaphragm. Electrons cannot pass through the diaphragm and can only move from the negative electrode to the positive electrode through the external circuit. When the battery is being charged, the cathode of the battery releases lithium ions, and the released lithium ions move to the anode through the electrolyte. Carbon as the anode has a layered structure, and has many micropores. Lithium ions that reach the anode are embedded in the micropores of the carbon layer. A larger quantity of embedded lithium ions leads to a higher charging capacity.

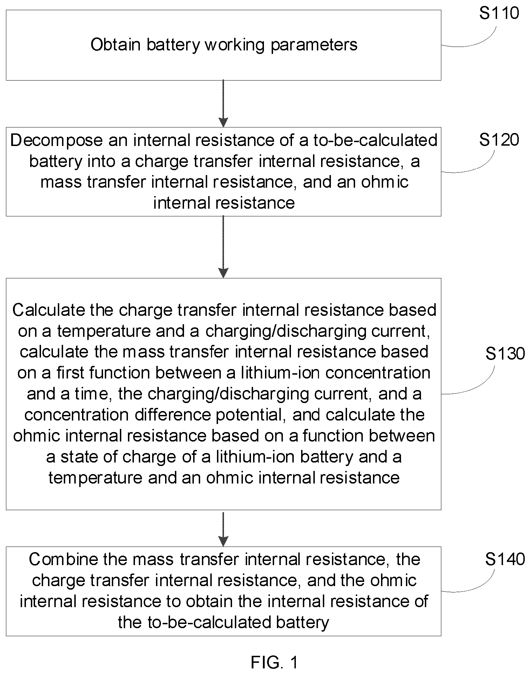

Refer to FIG. 1. FIG. 1 is a schematic flowchart of a method for calculating an internal resistance of a lithium-ion battery according to an embodiment of this application. As shown in FIG. 1, the voice intention recognition method includes at least step S110 to step S150. Details are described as follows:

Step S110: Obtain battery operating parameters, where the battery operating parameters include a temperature, a charging/discharging current, a concentration difference potential, a function between a lithium-ion concentration and a time, and a function between an ohmic internal resistance and aging of a lithium-ion battery.

In an embodiment of this application, the lithium-ion battery is an LFP (lithium iron phosphate, LiFePO4) battery. The concentration difference potential is a potential difference caused by a concentration difference of electrolyte solutions between two electrodes. The aging of the lithium-ion battery mainly includes a loss of available lithium ions (LLI) and a loss of positive and negative electrode active materials (LAM). The battery aging mechanism also includes an increase in internal resistance (RI) and a loss of electrolyte (LE): The increase in internal resistance will directly lead to the attenuation of battery power, and excessive electrolyte loss may directly lead to a capacity drop at the end of the battery life.

Step S120: Decompose an internal resistance of a to-be-calculated battery into a charge transfer internal resistance, a mass transfer internal resistance, and an ohmic internal resistance.

In an embodiment of this application, the to-be-calculated battery is an LFP (lithium iron phosphate, LiFePO4) battery. In a charging and discharging process, according to different physical and chemical processes that occur in the battery, the internal resistance of the lithium-ion battery may be decomposed into a charge transfer internal resistance, a mass transfer internal resistance, and an ohmic internal resistance. That is, the internal resistance of the lithium-ion battery is a sum of the three internal resistances. In an embodiment of this application, the internal resistance of the lithium-ion battery is calculated by using the following formula:

$$R_{tot} = R_{ct} + R_{mt} + R_\Omega \qquad \text{Formula (1)}$$

Here, $R_{tot}$ is the internal resistance of the lithium-ion battery, $R_{ct}$ is the charge transfer internal resistance, $R_{mt}$ is the mass transfer internal resistance, and $R_\Omega$ is the ohmic internal resistance.

In this embodiment, the charge transfer internal resistance is an electrochemical reaction electron transfer resistance, the mass transfer internal resistance is an internal resistance when lithium ions are transmitted in the electrolyte and the bulk phase of the electrode material, and the ohmic internal resistance mainly includes an electrode material, an electrolyte, a diaphragm resistance, and a contact resistance of each part. The impact of a plurality of factors on the internal resistance of the lithium-ion battery is considered, so that the calculated internal resistance of the lithium-ion battery is closer to an actual internal resistance of the lithium-ion battery. In addition, by detecting a change of the internal resistance of the lithium-ion battery, a person skilled in the art can learn of an aging condition of the lithium-ion battery in a timely manner, thereby performing repair and maintenance on the lithium-ion battery, so as to prolong a service life of the lithium-ion battery to a certain extent.

In an embodiment of this application, the internal resistance of the lithium-ion battery is affected by parameters such as a temperature, a current, a battery state of charge (SOC), and an aging time, and may be denoted as:

$$R_{tot} = f(I, T, x, t_0) \qquad \text{Formula (2)}$$

Here, $R_{tot}$ is the internal resistance of the lithium-ion battery, I is the charging/discharging current, T is the temperature, x is the battery state of charge, and $t_0$ is the battery aging time.

Step S130: Calculate the charge transfer internal resistance based on a temperature and a charging/discharging current, calculate the mass transfer internal resistance based on a first function between a lithium-ion concentration and a time, the charging/discharging current, and the concentration difference potential, and calculate the ohmic internal resistance based on the function between the state of charge of the lithium-ion battery and the temperature and the ohmic internal resistance.

Step S140: Combine the mass transfer internal resistance, the charge transfer internal resistance, and the ohmic internal resistance to obtain the internal resistance of the to-be-calculated battery.

In an embodiment of this application, a function for calculating a charge transfer internal resistance is established, a function for calculating a mass transfer internal resistance is established, a function for calculating an ohmic internal resistance is established, to calculate the internal resistance of the to-be-calculated battery, so that an internal resistance of the battery can be predicted more accurately, and the calculated internal resistance of the battery is more compatible with the actual internal resistance of the battery in an actual application scenario.

In the technical solution of the embodiment shown in FIG. 1, the impact of factors such as temperature, state of charge (SOC) of the lithium-ion battery, and charging/discharging current on the internal resistance of the lithium-ion battery is considered, and the function for calculating a charge transfer internal resistance, the function for calculating a mass transfer internal resistance, and the function for calculating an ohmic internal resistance are established. The internal resistance of the lithium-ion battery is calculated through the function of the internal resistance of each part of the lithium-ion battery, so that the internal resistance of the lithium-ion battery can be predicted more accurately, and the calculated internal resistance of the lithium-ion battery is more compatible with an actual application scenario.

In an embodiment of this application, the calculating the charge transfer internal resistance based on a temperature and a charging/discharging current includes: obtaining the charge transfer internal resistance by using a gas constant, a Faraday constant, the temperature, and the charging/discharging current. In an embodiment of this application, the charge transfer internal resistance is calculated by using the following formula:

$$R_{ct} = \frac{\partial \eta_{ct}}{\partial I} \qquad \text{Formula (3)}$$

Here, $\eta_{ct}$ is a battery charge transfer overpotential, and I is the charging/discharging current. $\eta_{ct}$ and I are obtained by using the following formula:

$$I = j_0 \left( exp\left(\frac{\alpha n F \eta_{ct}}{RT}\right) - exp\left(\frac{-\beta n F \eta_{ct}}{RT}\right) \right) \qquad \text{Formula (4)}$$

Here, $\alpha$ is an exchange coefficient, and in this embodiment, $\alpha$ is 0.5. $n$ is a quantity of transferred charges, and is 1 in a lithium-ion battery system. F is the Faraday constant, R is the gas constant, and T is the temperature. When the overpotential is large, the second calculation value on the right side in Formula (4) is small, which may be omitted. Therefore, Formula (4) may be simplified as follows:

$$I = j_0 \ exp\left(\frac{\alpha n F \eta_{ct}}{RT}\right) \qquad \text{Formula (5)}$$

$\eta_{ct}$ and I are substituted into (3) to obtain:

$$R_{ct} = \frac{RT}{\alpha nFI} \qquad \text{Formula (6)}$$

$R_{ct}$ is the charge transfer resistance, I is the charging/discharging current, F is the Faraday constant, R is the gas constant, and $\alpha$ is the exchange coefficient. In this embodiment, R=8.314, $\alpha$=0.5, F=96500, and n=1. Therefore, the

$$R_{ct} = -1.723 \times 10^{-4} \frac{T}{I}$$

charge transfer internal resistance may be $\qquad$ .

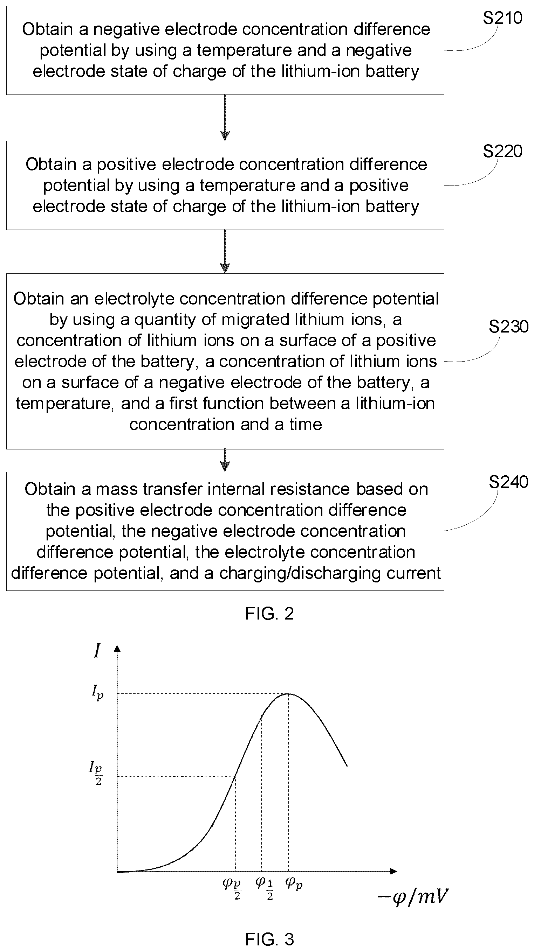

Refer to FIG. 2. FIG. 2 shows a schematic flowchart of step S130 of the method for calculating an internal resistance of a lithium-ion battery shown in FIG. 1 according to an example embodiment of this application. In the embodiment shown in FIG. 2, step S130 in the method for calculating an internal resistance of a lithium-ion battery in this embodiment includes the following steps:

Step 210: Obtain a negative electrode concentration difference potential by using a temperature and a negative electrode state of charge of the lithium-ion battery.

In an embodiment of this application, a lithium-ion transmission process is driven by a concentration gradient of ions, and the concentration gradient of the ions generates a corresponding potential difference, that is, a concentration difference potential. The concentration difference potential of the negative electrode is a concentration difference potential of the lithium-ion transmission process in the negative electrode. The concentration difference potential in the battery electrode may be determined by using the following formula:

$$\eta_{mt}^{s} = -\frac{RT}{F} \ln\left(\frac{\alpha_A}{\alpha_B}\right) \qquad \text{Formula (7)}$$

Here, $\alpha_A$ and $\alpha_B$ are respectively activity of a substance A and activity of a substance B. When the negative electrode is considered, $\alpha_A$ is the activity of the negative electrode in the delithiation state, and $\alpha_B$ is the activity of the negative electrode in the lithium insertion state. When the positive electrode is considered, $\alpha_A$ is the activity of the positive electrode in the delithiation state, and $\alpha_B$ is the activity of the positive electrode in the lithium insertion state. The relationship between activity and concentration may be represented as:

$$\alpha_A = f_A C_A$$

$$\alpha_B = f_B C_B$$

$C_A$ is a lithium-ion concentration in the delithiation state, $C_B$ is a lithium-ion concentration in the lithium insertion state, $f_A$ and $f_B$ are activity coefficients. In an embodiment of this application, the activity coefficient is 1, the concentration is equal to the activity, and Formula 7 may be rewritten as:

$$\eta_{mt}^{s} = -\frac{RT}{F} \ln\left(\frac{C_A}{C_B}\right) \qquad \text{Formula (8)}$$

In an embodiment of this application, the lithium-ion battery is in a charging state, and lithium ions inside the negative electrode are transmitted. The lithium-ion concentration $C_A$ in the delithiation state is calculated by using the following formula:

$$C_A = \frac{M_{C_6}}{\rho_{C_6}}(1 - x_1) \qquad \text{Formula (9)}$$

The concentration $C_B$ of lithium ions in the lithium insertion state is calculated by using the following formula:

$$C_{\mathrm{B}} = \frac{M_{C_6}}{\rho_{C_6}} x_1 \qquad \text{Formula (10)}$$

$M_{C6}$ is a molecular weight of a negative electrode of graphite, $\rho_{C6}$ is a negative electrode density of graphite, $x_1$ is a negative electrode SOC, $C_A$ is the lithium-ion concentration in the delithiation state, and $C_B$ is the lithium-ion concentration in the lithium insertion state.

Formula (9) and Formula (10) are substituted into Formula (8) to obtain a negative electrode concentration difference potential as follows:

$$\eta_{mt}^- = -\frac{RT}{F} \ln(\frac{1 - x_1}{x_1}) \qquad \text{Formula (11)}$$

Here, $\eta_{mt}^-$ is a concentration difference potential of the lithium-ion transmission process in the negative electrode, F is a Faraday constant, R is a gas constant, T is an ambient temperature, and $x_1$ is a negative electrode SOC.

Step 220: Obtain the positive electrode concentration difference potential by using a temperature and a positive electrode state of charge of the lithium-ion battery.

In an embodiment of this application, the positive electrode concentration difference potential is a concentration difference potential of the lithium-ion transmission process in the positive electrode, and is determined by using the following formula:

$$\eta_{mt}^+ = -\frac{RT}{F} \ln(\frac{1 - x_2}{x_2}) \qquad \text{Formula (12)}$$

Here, $\eta_{mt}^+$ is the concentration difference potential of the lithium-ion transmission process in the positive electrode, F is the Faraday constant, R is the gas constant, T is the ambient temperature, and $x_2$ is the positive electrode SOC.

Step 230: Obtain the electrolyte concentration difference potential by using a quantity of migrated lithium ions, a concentration of lithium ions at an electrolyte layer on a surface of a positive electrode of the battery, a concentration of lithium ions at an electrolyte layer on a surface of a negative electrode of the battery, a temperature, and the first function between a lithium-ion concentration and a time.

In an embodiment of this application, an initial electrolyte concentration difference potential is obtained by using the quantity of migrated lithium ions, the concentration of the lithium ions at the electrolyte layer on the surface of the positive electrode of the battery, the concentration of the lithium ions at the electrolyte layer on the surface of the negative electrode of the battery, a Faraday constant, a gas constant, and the temperature:

$$\eta_{mt}^e = \frac{2t_+ RT}{F} \ln\left(\frac{C_{Li}^{ca}}{C_{Li}^{an}}\right) \qquad \text{Formula (13)}$$

Here, $\eta_{mt}^e$ is the initial electrolyte concentration difference potential, F is the Faraday constant, R is the gas constant, T is the temperature, $t_+$ is the quantity of migrated lithium ions, $C_{Li}^{ca}$ is the concentration of lithium ions at the electrolyte layer on the surface of the positive electrode, and $C_{Li}^{an}$ is the concentration of the lithium ions at the electrolyte layer on the surface of the negative electrode. A change of the lithium-ion concentration may be described by using the Fick's second law, that is,

$$\frac{\partial C_{Li}}{\partial t} = D \nabla C_{Li} \qquad \text{Formula (14)}$$

Here, $C_{Li}$ is the lithium-ion concentration, t is a time, and D is a diffusion coefficient. D is a function of temperature, and may be represented as:

$$D = D_0 e^{\frac{-E_a}{RT}} \qquad \text{Formula (15)}$$

Here, $D_0$ is a pre-exponential factor, $E_a$ is an activation energy, R is the gas constant, and T is the temperature. Formula (15) is substituted into Formula (14) to obtain the final expression of the lithium-ion concentration change:

$$\frac{\partial C_{Li}}{\partial t} = D_0 e^{\frac{-E_a}{RT}} \nabla C_{Li} \qquad \text{Formula (16)}$$

Here, $D_0$ is the pre-exponential factor, $E_a$ is the activation energy, $C_{Li}$ is the lithium-ion concentration, R is the gas constant, T is the temperature, and t is the time.

In an embodiment of this application, the lithium-ion battery is a button cell, and FIG. 3 is a current and potential curve of cyclic voltammetry. A diffusion coefficient of lithium ions is calibrated by using a cyclic voltammetry experiment. In this embodiment, metallic lithium is used as a counter electrode to prepare button cells with positive and negative electrodes at different SOCs respectively; at different temperatures, a constant voltage change rate is applied to the button cells to be tested, and the current value is observed and recorded to obtain the current and concentration potential curve of cyclic voltammetry as shown in FIG. 2. By using the following equations, diffusion coefficients of lithium ions in positive and negative electrode materials of different SOCs under different temperature conditions are separately obtained:

$$\begin{cases} I_p = 2.69 \times 10^5 n^{3/2} D^{1/2} v^{1/2} C_0^0 \\ \\ n - \dfrac{28}{\varphi_{1/2} \; \varphi_p} \end{cases} \qquad \text{Formula (17)}$$

$I_p$ is a peak value of the charging/discharging current, D is the diffusion coefficient, v is the voltage change rate, n is a coefficient, $C_0$ is a lithium-ion concentration constant, and $\varphi_p$ is a peak value of the potential.

$$\varphi_{\frac{1}{2}} = \frac{\varphi_p - \varphi_{\frac{p}{2}}}{2} \qquad \text{Formula (18)}$$

By combining Formula (17) and Formula (18), diffusion coefficients of lithium ions in positive and negative electrode materials at different SOCs are obtained.

The diffusion coefficients of lithium ion in the positive and negative electrode materials at different SOCs are substituted into Formula (15), to obtain a value of the activation energy and a value of the pre-exponential factor through calculation. The value of the activation energy and the value of the pre-exponential factor are substituted into Formula (16), and Formula (16) is integrated, to obtain the first function between a lithium-ion concentration and a time.

$$C(t) = f_C (t, T) \qquad \text{Formula (19)}$$

The electrolyte concentration difference potential $\eta_{\text{mt}}^{E}$ is obtained based on the first function between a lithium-ion concentration and a time and the initial electrolyte concentration difference potential:

$$\eta_{\text{mt}}^{E} = f_{\text{e}}(T, t_0) \qquad \text{Formula (20)}$$

Here, $\eta_{\text{mt}}^{E}$ is the electrolyte concentration difference potential, T is the temperature, and $t_0$ is a battery aging time.

Step 240: Obtain the mass transfer internal resistance based on the positive electrode concentration difference potential, the negative electrode concentration difference potential, the electrolyte concentration difference potential, and the charging/discharging current.

In an embodiment of this application, the positive electrode concentration difference potential, the negative electrode concentration difference potential, and the electrolyte concentration difference potential are summed, to obtain a first total concentration difference potential. The ratio of the first total concentration difference potential to the charging/-discharging current is determined as the mass transfer internal resistance. In this embodiment, the mass transfer internal resistance is calculated by using the following formula:

$$R_{mt} = \frac{\eta_{mt}^{+} + \eta_{mt}^{-} + \eta_{mt}^{E}}{I} \qquad \text{Formula (21)}$$

Here, $R_{mt}$ is the mass transfer internal resistance, $\eta_{mt}^{+}$ is the positive electrode concentration difference potential, $\eta_{mt}^{-}$ is the negative electrode concentration difference potential, $\eta_{mt}^{E}$ is the electrolyte concentration difference potential, and I is the charging/discharging current. In this embodiment, $x_1 = x_2$, R=8.314, and F=96500. The mass transfer internal resistance is obtained through calculation:

$$R_{mt} = -1.723 \times 10^{-4} \frac{T}{I} \ln\left(\frac{(1 - x_1)}{x_1}\right) + \frac{f_{\text{e}}(T, t_0)}{I} \qquad \text{Formula (22)}$$

Here, $R_{mt}$ is the mass transfer internal resistance, T is the temperature, I is the charging/discharging current, $t_0$ is a battery aging time, $x_1$ is the negative electrode SOC, and $x_2$ is the positive electrode SOC.

In the technical solution of the embodiment shown in FIG. 2, in a case of calculating the mass transfer internal resistance, the concentration difference potential is decomposed into a positive electrode concentration difference potential, a negative electrode concentration difference potential, and an electrolyte concentration difference potential, so as to separately calculate each potential. The influences of a plurality of factors on the concentration difference potential are considered, so that an error in calculating the concentration difference potential can be reduced, and a more accurate mass transfer internal resistance can be obtained.

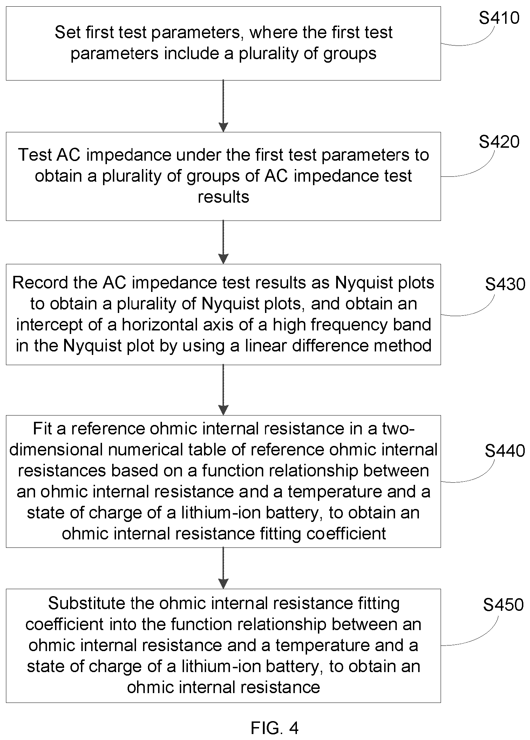

Refer to FIG. 4. FIG. 4 shows a schematic flowchart of step S130 of the method for calculating an internal resistance of a lithium-ion battery shown in FIG. 1 according to an example embodiment of this application. In the embodiment shown in FIG. 2, step S130 in the method for calculating an internal resistance of a lithium-ion battery in this embodiment further includes the following steps:

Step 410: Set first test parameters, where the first test parameters include a state of charge, a reference ambient temperature, and a preset frequency range of a lithium-ion battery, and the first test parameters include a plurality of groups.

In an embodiment of this application, the lithium-ion battery is an LFP (lithium iron phosphate, LiFePO4) battery. The SOC of the lithium-ion battery is adjusted to $x_0$, the reference ambient temperature is $T_0$, and the preset frequency range is 100 KHz to 0.1 Hz. This is the first group of first test parameters. The SOC of the battery is adjusted to $x_1$, the reference ambient temperature is $T_1$, and the preset frequency range is 100 KHz to 0.1 Hz. This is the second group of first test parameters. The SOC of the battery is adjusted to $x_3$, the reference ambient temperature is $T_3$, and the preset frequency range is 100 KHz to 0.1 Hz. This is the third group of first test parameters. By setting a plurality of groups of test parameters to test the AC impedance of the battery, a more accurate ohmic internal resistance can be obtained.

Step 420: Test AC impedance under the first test parameters to obtain a plurality of groups of AC impedance test results.

Step 430: Record the AC impedance test results as Nyquist plots to obtain a plurality of Nyquist plots, and obtain an intercept of a horizontal axis of a high frequency band in the Nyquist plot by using a linear difference method.

In an embodiment of this application, when the electrode system is disturbed by an alternating current signal of a sinusoidal waveform voltage (current), a corresponding current (voltage) response signal is generated, and impedance or admittance of the electrode may be obtained from these signals. The impedance spectrum generated by a series of sinusoidal wave signals is called electrochemical impedance spectroscopy (EIS), also known as AC impedance spectroscopy. In electrochemical workstation testing, it is called AC impedance (AC Impedance). Impedance measurement is originally a method in electrical engineering to study the frequency response characteristics of linear circuit networks. It is applied to the study of electrode processes and becomes an experimental method in electrochemical research. The impedance of a working electrode is measured in a three-electrode system. The information in the EIS is usually represented by a Nyquist plot (Nyquist plot). In the Nyquist plot, a negative imaginary component of the impedance (y-axis) is plotted against a real component of the impedance (x-axis).

Step 440: Fit a reference ohmic internal resistance in a two-dimensional numerical table of reference ohmic internal resistances based on a function between an ohmic internal resistance and a temperature and a state of charge of a lithium-ion battery, to obtain an ohmic internal resistance fitting coefficient.

Step 450: Substitute the ohmic internal resistance fitting coefficient into the function between an ohmic internal resistance and a temperature and a state of charge of a lithium-ion battery, to obtain an ohmic internal resistance.

In an embodiment of this application, the ohmic internal resistance fitting coefficient is substituted into the function between a state of charge of a lithium-ion battery and a temperature and an ohmic internal resistance, to obtain an ohmic internal resistance:

$$R_\Omega = R_\Omega^0 (1 + ax + bT + cxT) \qquad \text{Formula (23)}$$

Here, $R_\Omega$ is the ohmic internal resistance, $R_\Omega^0$ is an ohmic internal resistance at a reference temperature, T is a temperature, and x is a battery state of charge. a, b, and c are ohmic internal resistance fitting coefficients.

In the technical solution of the embodiment shown in FIG. 4, by analyzing the Nyquist plot, a plurality of reference ohmic internal resistances are obtained, and the reference ohmic internal resistances are fitted, so that a more accurate ohmic internal resistance can be obtained, and a more accurate lithium-ion battery internal resistance can be obtained.

In an embodiment of this application, the internal resistance of the lithium-ion battery is calculated by using Formula (1), R=8.314, F=96500, and $x_1=x_2=x$, and the internal resistance of the lithium-ion battery is obtained:

$$R_{tot} = -1.723 \times 10^{-4} \frac{T}{I} \left[ 1 + \ln \frac{(1-x_1)}{x_1} \right] + \frac{f_e(T, t_0)}{I} + R_\Omega^0 (1 + ax + bT + cxT)$$

Formula (24)

Here, T is the temperature, I is the charging/discharging current, $t_0$ is a battery aging time, $x_1$ is the negative electrode SOC, and $x_2$ is the positive electrode SOC. $R_\Omega^0$ is the ohmic internal resistance at the reference temperature, and x is the lithium-ion battery SOC. a, b, and c are ohmic internal resistance fitting coefficients.

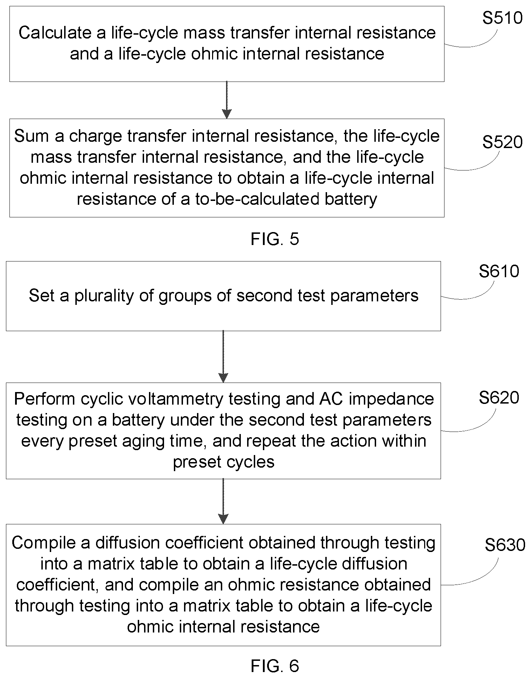

Refer to FIG. 5. FIG. 5 shows a schematic flowchart of step S140 of the method for calculating an internal resistance of a lithium-ion battery shown in FIG. 1 according to an example embodiment of this application. In the embodiment shown in FIG. 5, step S140 in the method for calculating an internal resistance of a lithium-ion battery in this embodiment further includes the following steps:

Step 510: Calculate a life-cycle mass transfer internal resistance and a life-cycle ohmic internal resistance.

In an embodiment of this application, the calculating a life-cycle mass transfer internal resistance includes:

obtaining a life-cycle electrolyte concentration difference potential $\eta_{\mathrm{mt}}^{h}$ based on the initial electrolyte concentration difference potential and a second function between a lithium-ion concentration and a time:

$$\eta_{\mathrm{mt}}^{\mathrm{h}} = f_{\mathrm{h}}(T, t_0, x, I) \qquad \text{Formula (25)}$$

Here, $\eta_{\mathrm{mt}}^{h}$ is the life-cycle electrolyte concentration difference potential, $t_0$ is the battery aging time, T is the ambient temperature, x is the battery SOC, and I is the charging/discharging current. The positive electrode concentration difference potential, the negative electrode concentration difference potential, and the life-cycle electrolyte concentration difference potential are summed to obtain a second total concentration difference potential. A ratio of the second total concentration difference potential to the charging/discharging current is determined as the life-cycle mass transfer internal resistance. In an embodiment of this application, the life-cycle mass transfer internal resistance is calculated by using the following formula:

$$R_{mt}^{\mathrm{h}} = \frac{\eta_{mt}^{+} + \eta_{mt}^{-} + \eta_{mt}^{\mathrm{h}}}{I} \qquad \text{Formula (26)}$$

$R_{mt}^{h}$ is the life-cycle mass transfer internal resistance, $\eta_{mt}^{+}$ is the positive electrode concentration difference potential, $\eta_{mt}^{-}$ is the negative electrode concentration difference potential, $\eta_{\mathrm{mt}}^{h}$ is the life-cycle electrolyte concentration difference potential, and I is the charging/discharging current.

In this embodiment, R=8.314, F=96500, $x_1=x_2$, and Formula (11), Formula (12), and Formula (25) are substituted into Formula (26) to calculate the life-cycle mass transfer internal resistance:

$$R_{mt}^{\mathrm{h}} = -1.723 \times 10^{-4} \frac{T}{I} \ln \frac{(1-x_1)}{x_1} + \frac{f_e(T, t_0, x, I)}{I} \qquad \text{Formula (27)}$$

Here, $R_{\mathrm{mt}}^{h}$ is the life-cycle mass transfer internal resistance, $t_0$ is the battery aging time, T is the ambient temperature, I is the charging/discharging current, $x_1$ is the negative electrode SOC, and x is the lithium-ion battery SOC.

In an embodiment of this application, the calculating the life-cycle mass transfer internal resistance includes: obtaining an initial ohmic internal resistance of the lithium-ion battery by using a function between an ohmic internal resistance and a state of charge of the lithium-ion battery and a temperature. In an embodiment of this application, the initial ohmic internal resistance of the lithium-ion battery is calculated by using Formula (23).

In an embodiment of this application, main factors that affect a battery life are: a high temperature (accelerating internal side reactions); a low temperature (causing easy reduction of metal ions, lithium precipitation, easy destruction of a crystal structure of active materials); a high battery SOC or overcharge (causing electrolyte decomposition, side reactions between electrolyte and positive electrode, and lithium-ion deposition); a low battery SOC or overdischarge (a negative copper collector is easy to corrode and the crystal structure of the active materials is easy to peel off); a high charging/discharging rate (the crystal structure of the active materials is easy to fatigue and damage, and the high charging/discharging rate causes high temperature rise to accelerate the internal side reactions).

Therefore, after the battery is aged, the thickness of the solid-state electrolyte membrane on the positive and negative electrode surfaces increases with time, and the material structure deteriorates with time. The relationship between the thickness of the solid-state electrolyte membrane and the aging time may be approximately expressed as follows:

$$l = 1 + \beta \ln(1 + \theta t_0) \qquad \text{Formula (28)}$$

Here, I is the thickness of the solid-state electrolyte membrane, $\beta$ and $\theta$ are constants, and $t_0$ is the battery aging time.

In this embodiment, because the ohmic resistance is approximately proportional to the thickness of the solid-state electrolyte membrane, a function between the ohmic internal resistance and aging of the lithium-ion battery is obtained according to the initial ohmic internal resistance and a relationship between the thickness of the solid-state electrolyte membrane and aging of the lithium-ion battery:

$$f_\Omega(t) = R_\Omega^{re}(1 + \beta \ln(1 + \theta t_0)) \qquad \text{Formula (29)}$$

$R_\Omega^{re}$ represents the initial ohmic internal resistance when the battery is in an initial state, $\beta$ and $\theta$ are constants, and $t_0$ is the battery aging time. The impact of battery aging on an internal resistance of a lithium-ion battery is considered, and a life-cycle resistance of the lithium-ion battery is calculated, so that the internal resistance of the lithium-ion battery is closer to an actual internal resistance of the lithium-ion battery, and accuracy of predicting the internal resistance of the battery is improved. In addition, by detecting a change of the internal resistance of the lithium-ion battery, a person skilled in the art can learn of an aging condition of the lithium-ion battery in a timely manner, thereby performing repair and maintenance on the lithium-ion battery, so as to prolong a service life of the lithium-ion battery to a certain extent.

In an embodiment of this application, the life-cycle ohmic internal resistance is obtained according to the relationship between an ohmic internal resistance and a state of charge of a lithium-ion battery and an ambient temperature and a function between an ohmic internal resistance and aging of a lithium-ion battery. In an embodiment of this application, Formula (23) is substituted into Formula (29) to obtain a life-cycle ohmic internal resistance:

$$R_\Omega^h = R_\Omega^0(1 + ax + bT + cxT)(1 + \beta \ln(1 + \theta t_0)) \qquad \text{Formula (30)}$$

Here, $R_\Omega^h$ is the life-cycle ohmic internal resistance, $R_\Omega^0$ is an ohmic internal resistance at a reference temperature, T is a temperature, x is the state of charge of the battery, $t_0$ is the battery aging time, a, b, and c are to-be-fitted coefficients, and $\beta$ and $\theta$ are constants.

Step 520: Sum the charge transfer internal resistance, the life-cycle mass transfer internal resistance, and the life-cycle ohmic internal resistance to obtain a life-cycle internal resistance of a to-be-calculated battery.

In an embodiment of this application, R=8.314, F=96500, and a charge transfer resistance is considered as a constant in a full life cycle. The life-cycle resistance of the to-be-calculated battery may be represented as follows:

$$R_{tot}^h = R_{ct} + R_{mt}^h + R_\Omega^h \qquad \text{Formula (31)}$$

Here, $R_{tot}^h$ is the life-cycle internal resistance of the to-be-calculated battery, $R_{ct}$ is the charge transfer internal resistance, $R_{mt}^h$ is the life-cycle mass transfer internal resistance, and $R_\Omega^h$ is the life-cycle ohmic internal resistance.

In an embodiment of this application, Formula (6), Formula (27), and Formula (30) are substituted into Formula (31), where R=8.314, F=96500, and $x_1 = x_2 = x$, to obtain the life-cycle internal resistance of the to-be-calculated battery.

$$R_{tot}^h = -1.723 \times 10^{-4} \frac{T}{I}\left[1 + \ln\left(\frac{(1 - x_1)}{x_1}\right)\right] + \frac{f_e(T, t_0, x, I)}{I} + R_\Omega^0(1 + ax + bT + cxT)(1 + \beta \ln(1 + \theta t_0))$$

Formula (32)

Here, $R_{tot}^{h}$ is the life-cycle internal resistance of the to-be-calculated battery, T is the temperature, I is the charging/discharging current, $t_0$ is the battery aging time, $x_1$ is the negative electrode SOC, $R_{\Omega}^{0}$ is the ohmic internal resistance at the reference temperature, and x is the battery SOC. a, b, and c are ohmic internal resistance fitting coefficients.

In the technical solution shown in FIG. 5, the life-cycle mass transfer internal resistance and the life-cycle ohmic internal resistance are calculated, so that the life-cycle internal resistance of the to-be-calculated battery is obtained. In this way, a change rule of the life-cycle internal resistance of the battery is considered, so that the predicted internal resistance of the battery is closer to the internal resistance of the battery in an actual use process.

Refer to FIG. 6. FIG. 6 shows that before step S510 of the method for calculating an internal resistance of a lithium-ion battery shown in FIG. 5 according to an example embodiment of this application, the following steps are further included:

Step S610: Set a plurality of groups of second test parameters, where the second test parameters include an ambient temperature, a charging/discharging current, and a battery state of charge, and a preset quantity of electric cells are selected for each group of test parameters.

Step S620: Perform cyclic voltammetry testing and AC impedance testing on a battery under the second test parameters every preset aging time, and repeat the action within preset cycles, where the cyclic voltammetry test is used to calibrate the diffusion coefficient of lithium ions, and the AC impedance test is used to calibrate the ohmic internal resistance.

In an embodiment of this application, the preset quantity of electric cells are 6 electric cells, the preset aging time is 1 month, and the preset cycles are 6 cycles. The first group of second test parameters includes an ambient temperature $T_1$, a charging/discharging current $I_1$, and a battery $SOCx_1$. The second group of second test parameters includes an ambient temperature $T_2$, a charging/discharging current $I_2$, and a battery $SOCx_2$. The third group of second test parameters includes an ambient temperature $T_3$, a charging/discharging current $I_3$, and a battery $SOCx_3$. Cyclic aging testing and calendar aging testing are performed on the battery under each group of second test parameters. In this embodiment, a cyclic voltammetry test and an AC impedance test are performed according to each set of second test parameters every one month of battery aging time, and the lithium-ion diffusion coefficient and the ohmic resistance under corresponding aging conditions are calculated. This is repeated for 6 cycles.

Step S630: Compile a diffusion coefficient obtained through testing into a matrix table to obtain a life-cycle diffusion coefficient $D(t)=f_D(I, T, x, t_0)$, and compile an ohmic resistance obtained through testing into a matrix table to obtain a life-cycle ohmic internal resistance $R_{\Omega}(t)=f_{\Omega}(t_0, x, I, T)$. I is the charging/discharging current, T is the ambient temperature, x is the battery state of charge, and $t_0$ is the aging time.

In the technical solution shown in FIG. 6, the life-cycle diffusion coefficient and the life-cycle ohmic internal resistance are obtained through experimental testing, so as to calculate the life-cycle internal resistance of the to-be-calculated battery according to the life-cycle diffusion coefficient and the life-cycle ohmic internal resistance. In this way, a change rule of the life-cycle internal resistance of the battery is considered, so that the predicted internal resistance of the battery is closer to the internal resistance of the battery in an actual use process.

In an embodiment of this application, the life-cycle diffusion coefficient $D(t)=f_D(I, T, X, t)$ is substituted into Formula (15) to calculate the activation energy Ea and the pre-exponential factor $D_0$, the values of Ea and $D_0$ are substituted into Formula 16, and Formula 16 is integrated to obtain a change rule of the lithium-ion concentration with time:

$$C(t) = f_C(t_0, T, x, I) \qquad \text{Formula (33)}$$

C is the concentration, I is the charging/discharging current, T is the ambient temperature, x is a battery charge value, and $t_0$ is the aging time. Formula (33) is substituted into Formula (13) to obtain Formula (25). In an embodiment of this application, $R_{\Omega}(t)=f_{\Omega}(t_0, x, I, T)$ is substituted into Formula (27), values of $\beta$ and $\theta$ are obtained through fitting, and the values of $\beta$ and $\theta$ are substituted into Formula (30), to calculate the life-cycle ohmic internal resistance, so that the life-cycle resistance of the to-be-calculated battery is obtained according to Formula (32).

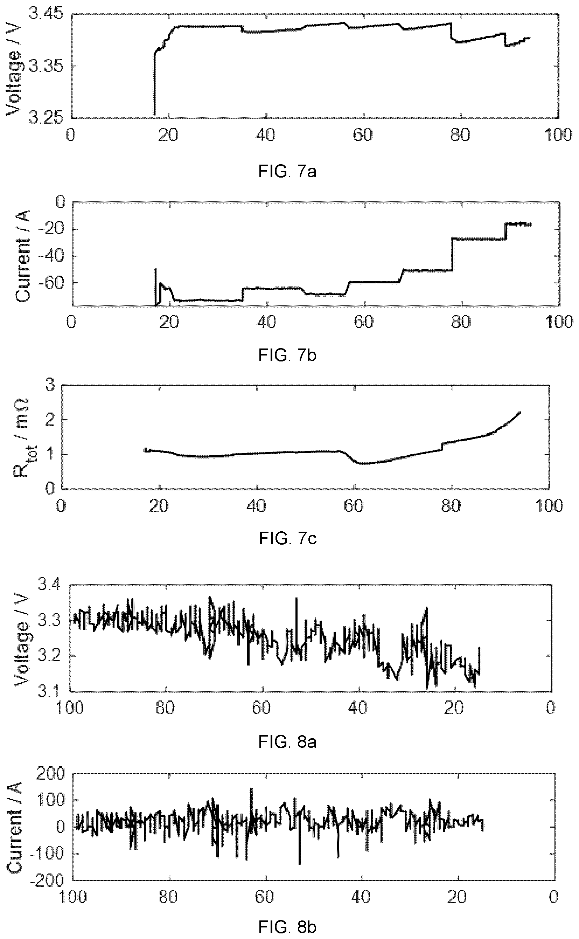

In an embodiment of this application, the lithium-ion battery is an LFP (lithium iron phosphate, LiFePO4) battery. FIG. 7 is a diagram of a change of a voltage, a current, and a resistance of an LFP (lithium iron phosphate, LiFePO4) battery under a fast charging condition. FIG. 7a is a curve graph showing changes of an SOC and a voltage of an LFP battery under a fast charging condition; FIG. 7b is a curve graph showing changes of an SOC and a current of an LFP battery under a fast charging condition; FIG. 7C is a curve graph showing changes of an SOC and a resistance of an LFP battery under a fast charging condition. In this embodiment, the aging time $t_0$ is 0, and the temperature T is 25 degrees Celsius. As shown in FIG. 7, in the fast charging condition, a voltage and a current that are corresponding to the LFP battery SOC value 0% to 100% are substituted into Formula (24) for calculation, to obtain a battery internal resistance corresponding to the LFP battery SOC value, to form a curve of the LFP battery SOC value-the LFP battery internal resistance in the fast charging condition.

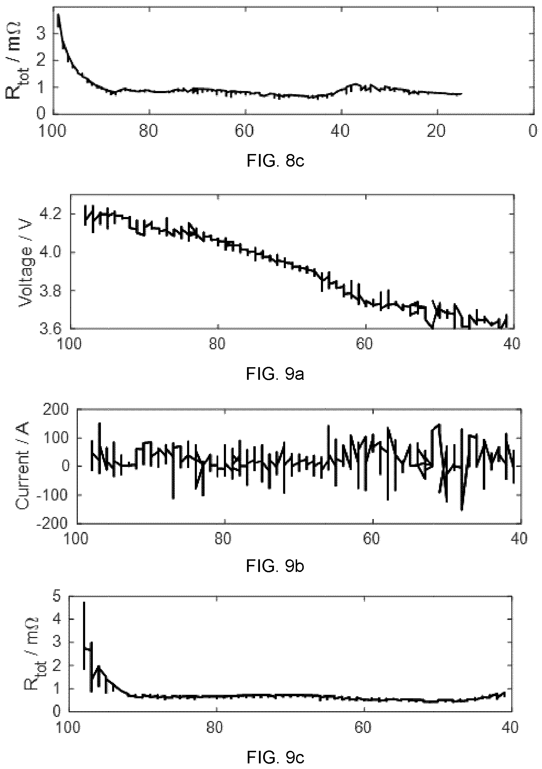

In an embodiment of this application, the lithium-ion battery is an LFP (lithium iron phosphate, LiFePO4) battery. FIG. 8 is a diagram of a change of a voltage, a current, and a resistance of an LFP (lithium iron phosphate, LiFePO4) battery in a driving condition. FIG. 8a is a curve graph showing changes of an SOC and a voltage of an LFP battery in a driving condition; FIG. 8b is a curve graph showing changes of an SOC and a current of an LFP battery in a driving condition; FIG. 8c is a curve graph showing changes of an SOC and a resistance of an LFP battery in a driving condition. In this embodiment, the aging time $t_0$ is 0, and the temperature T is 25 degrees Celsius. As shown in FIG. 8, in the driving condition, a voltage and a current that are corresponding to the LFP battery SOC value 0% to 100% are substituted into Formula (24) for calculation, to obtain a battery internal resistance corresponding to the LFP battery SOC value, to form a curve of the LFP battery SOC value-the LFP battery internal resistance in the driving condition.

In an embodiment of this application, the lithium-ion battery is an NMC (lithium nickel manganese cobalt, LiNixMnyCozO$_2$) battery. FIG. 9 shows a change of a voltage, a current, and a resistance of an NMC (lithium nickel manganese cobalt, LiNixMnyCozO$_2$) battery in a driving condition. FIG. 9a is a curve graph showing changes of an SOC and a voltage of an NMC battery in a driving condition; FIG. 9b is a curve graph showing changes of an SOC and a current of an NMC battery in a driving condition; FIG. 9c is a curve graph showing changes of an SOC and a resistance of an NMC battery in a driving condition. In this embodiment, the aging time $t_0$ is 0, and the temperature T is 25 degrees Celsius. As shown in FIG. 9, a voltage and a current that are corresponding to the NMC battery SOC value 0% to 100% are substituted into Formula (24) for calculation, to obtain a battery internal resistance corresponding to the NMC battery SOC value, to form a curve of the NMC battery SOC value-the LFP battery internal resistance in the driving condition.

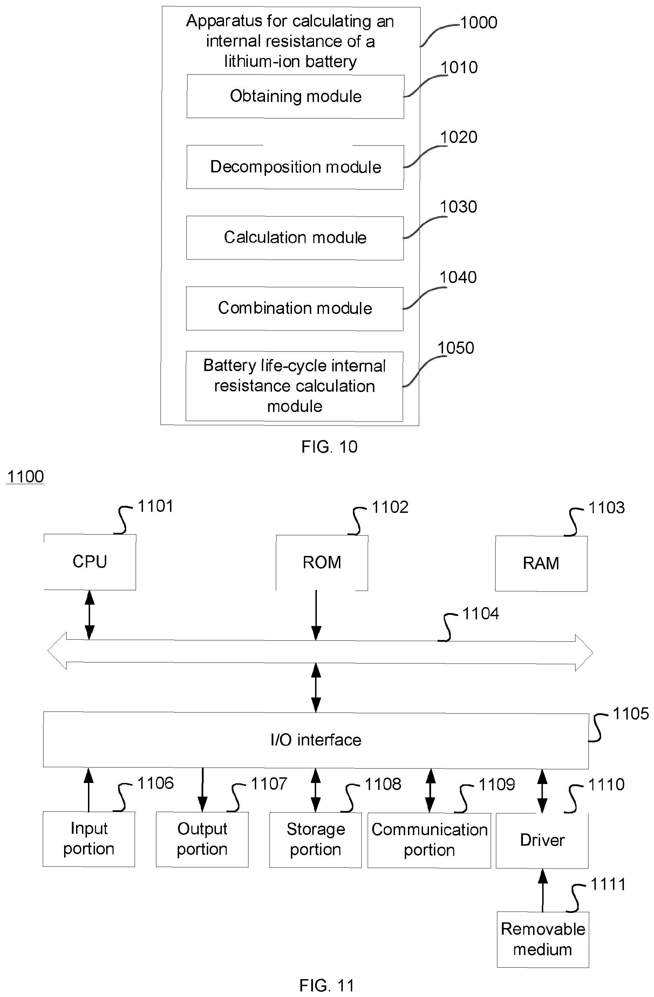

FIG. 10 shows a schematic diagram of an apparatus for calculating an internal resistance of a lithium-ion battery according to an example embodiment of the present invention. As shown in FIG. 10, the apparatus 1000 for calculating an internal resistance of a lithium-ion battery according to an embodiment of the present invention includes: an obtaining module 1010, a decomposition module 1020, a calculation module 1030, and a combination module 1040.

The obtaining module 1010 is configured to obtain a function between a lithium-ion concentration and a time, and obtain a life-cycle ohmic internal resistance; the decomposition module 1020 is configured to decompose an internal resistance of a to-be-calculated battery into a charge transfer internal resistance, a mass transfer internal resistance, and an ohmic internal resistance; the calculation module 1030 is configured to: calculate the charge transfer internal resistance based on the temperature and a charging/discharging current, calculate the mass transfer internal resistance based on the function between a lithium-ion concentration and a time, the charging/discharging current, and the concentration difference potential, and calculate the ohmic internal resistance based on the function between aging of the lithium-ion battery and the temperature and the ohmic internal resistance; and the combination module 1040 is configured to combine the mass transfer internal resistance, the charge transfer internal resistance, and the ohmic internal resistance to obtain the internal resistance of the to-be-calculated battery.

In an example embodiment of the present invention, the calculation module 1030 is configured to obtain the charge transfer internal resistance by using a gas constant, a Faraday constant, the temperature, and the charging/-discharging current.

In an example embodiment of the present invention, the calculation module 1030 is configured to obtain the negative electrode concentration difference potential by using a temperature and a negative electrode state of charge of the lithium-ion battery; obtain the positive electrode concentration difference potential by using a temperature and a positive electrode state of charge of the lithium-ion battery; obtain the electrolyte concentration difference potential by using a quantity of migrated lithium ions, a concentration of lithium ions at an electrolyte layer on a surface of a positive electrode of the battery, a concentration of lithium ions at an electrolyte layer on a surface of a negative electrode of the battery, a temperature, and the first function between a lithium-ion concentration and a time; and obtain the mass transfer internal resistance based on the positive electrode concentration difference potential, the negative electrode concentration difference potential, the electrolyte concentration difference potential, and the charging/discharging current.

In an example embodiment of the present invention, the calculation module 1030 is configured to obtain the negative electrode concentration difference potential by using the following formula:

$$\eta_{mt}^{-} = -\frac{RT}{F}\ln\left(\frac{1-x_1}{x_1}\right)$$

Here, $\eta_{mt}^{-}$ is the concentration difference potential of a lithium-ion transmission process in a negative electrode, F is the Faraday constant, R is the gas constant, T is the temperature, and $x_1$ is the negative electrode state of charge.

In an example embodiment of the present invention, the calculation module 1030 is configured to obtain the positive electrode concentration difference potential by using the following formula:

$$\eta_{mt}^{+} = -\frac{RT}{F} \ln(\frac{1-x_2}{x_2})$$

Here, $\eta_{mt}^{+}$ is the concentration difference potential in a lithium-ion transmission process at the positive electrode, F is the Faraday constant, R is the gas constant, T is the ambient temperature, and $x_2$ is the positive electrode state of charge.

In an example embodiment of the present invention, the calculation module 1030 is configured to obtain an initial electrolyte concentration difference potential by using the quantity of migrated lithium ions, the concentration of the lithium ions at the electrolyte layer on the surface of the positive electrode of the battery, the concentration of the lithium ions at the electrolyte layer on the surface of the negative electrode of the battery, a Faraday constant, a gas constant, and the temperature:

$$\eta_{mt}^{e} = \frac{2t_{+}RT}{F} \ln\left(\frac{C_{Li}^{ca}}{C_{Li}^{an}}\right)$$

Here, $\eta_{mt}^{e}$ is the initial electrolyte concentration difference potential, $t_+$ is the quantity of migrated lithium ions, $C_{Li}^{ca}$ is the concentration of the lithium ions at the electrolyte layer on the surface of the positive electrode, $C_{Li}^{an}$ is the concentration of the lithium ions at the electrolyte layer on the surface of the negative electrode, F is the Faraday constant, R is the gas constant, and T is the temperature; and obtaining the electrolyte concentration difference potential $\eta_{mt}^{E}$ based on the first function between a lithium-ion concentration and a time and the initial electrolyte concentration difference potential:

$$\eta_{mt}^{E} = f_{e}(T, t_0)$$

Here, $\eta_{mt}^{E}$ is the electrolyte concentration difference potential, T is the temperature, and $t_0$ is a battery aging time.

In an example embodiment of the present invention, the calculation module 1030 is configured to sum the positive electrode concentration difference potential, the negative electrode concentration difference potential, and the electrolyte concentration difference potential, to obtain a first total concentration difference potential, and determine a ratio of the first total concentration difference potential to the charging/discharging current as the mass transfer internal resistance.

In an example embodiment of the present invention, the calculation module 1030 is configured to: set first test parameters, where the first test parameters include the state of charge, the reference ambient temperature, and a preset frequency range of the lithium-ion battery, and there are a plurality of groups of the first test parameters; test AC impedance under the first test parameters to obtain a plurality of groups of AC impedance test results; record the AC impedance test results as Nyquist plots to obtain a plurality of Nyquist plots, and obtain an intercept of a horizontal axis of a high frequency band in the Nyquist plot by using a linear difference method; record the intercept of the Nyquist plot as an ohmic internal resistance under a corresponding test parameter, to obtain a plurality of reference ohmic internal resistances, and output a two-dimensional numerical table of the reference ohmic internal resistances; fit a reference ohmic internal resistance in the two-dimensional numerical table of the reference ohmic internal resistances based on a function between an ohmic internal resistance and a temperature and a state of charge of a lithium-ion battery, to obtain an ohmic internal resistance fitting coefficient; and substitute the ohmic internal resistance fitting coefficient into the function between an ohmic internal resistance and a temperature and a state of charge of a lithium-ion battery, to obtain an ohmic internal resistance.

In an example embodiment of the present invention, the apparatus for calculating an internal resistance of a lithium-ion battery further includes a battery life-cycle internal resistance calculation module 1050. The battery life-cycle internal resistance calculation module 1050 is configured to calculate a life-cycle mass transfer internal resistance and a life-cycle ohmic internal resistance, and sum the charge transfer internal resistance, the life-cycle mass transfer internal resistance, and the life-cycle ohmic internal resistance, to obtain the life-cycle internal resistance of the to-be-calculated battery.

In an example embodiment of the present invention, the battery full life cycle internal resistance calculation module 1050 is configured to: obtain a life-cycle electrolyte concentration difference potential $\eta_{mt}^{Eh}$ based on the initial electrolyte concentration difference potential and a second function between a lithium-ion concentration and a time:

$$\eta_{mt}^{h} = f_{e}(T, t_0, x, I)$$

where $\eta_{mt}^{h}$ is the electrolyte concentration difference potential, $t_0$ is the battery aging time, T is the ambient temperature, x is the battery state of charge, and I is the charging/discharging current; sum the positive electrode concentration difference potential, the negative electrode concentration difference potential, and the life-cycle electrolyte concentration difference potential to obtain a second total concentration difference potential; and determine a ratio of the second total concentration difference potential to the charging/discharging current as the life-cycle mass transfer internal resistance.

In an example embodiment of the present invention, the battery life-cycle internal resistance calculation module 1050 is configured to: obtain an initial ohmic internal resistance of the lithium-ion battery by using a function between an ohmic internal resistance and a state of charge of the lithium-ion battery and a temperature; obtain a function between the ohmic internal resistance and aging of the lithium-ion battery according to the initial ohmic internal resistance and a relationship between a thickness of a solid-state electrolyte membrane and aging of the lithium-ion battery:

$$f_{\Omega}(t) = R_{\Omega}^{re}(1 + \beta \ln(1 + \theta t_0))$$

Here, $R_{\Omega}^{re}$ represents the initial ohmic internal resistance of the lithium-ion battery in an initial state, β and θ are constants, and $t_0$ is a battery aging time; and obtaining the life-cycle ohmic internal resistance according to the function between an ohmic internal resistance and a state of charge of the lithium-ion battery and an ambient temperature and the function between the ohmic internal resistance and the aging of the lithium-ion battery:

$$R_{\Omega}^{h} = R_{\Omega}^{0}(1 + ax + bT + cxT)(1 + \beta \ln(1 + \theta t_0))$$

Here, $R_{\Omega}^{h}$ is the life-cycle ohmic internal resistance, $R_{\Omega}^{0}$ is an ohmic internal resistance at a reference temperature, T is a temperature, x is the state of charge of the battery, $t_0$ is the battery aging time, a, b, and c are to-be-fitted coefficients, and β and θ are constants.

It should be noted that the apparatus provided in the foregoing embodiment and the method provided in the foregoing embodiment belong to a same concept. A specific manner in which each module and unit perform an operation is described in detail in the method embodiment. Details are not described herein again. In actual applications, the apparatus provided in the foregoing embodiment may allocate the foregoing functions to different functional modules according to a requirement, that is, divide an internal structure of the apparatus into different functional modules, to complete all or some functions described above. This is not limited herein.

FIG. 11 is a schematic diagram of a structure of a computer system suitable for implementing an electronic device according to an embodiment of this application. It should be noted that the computer system 1100 of the electronic device shown in FIG. 11 is merely an example, and should not impose any limitation on a function and a use range of the embodiments of this application.

As shown in FIG. 11, the computer system 1100 includes a central processing unit (CPU) 1101. The CPU may perform various proper actions and processing based on a program stored in a read-only memory (ROM) 1102 or a program loaded from a storage portion 1108 to a random access memory (RAM) 1103, for example, perform the method provided in the foregoing embodiments. The RAM 1103 further stores various programs and data required for a system operation. The CPU 1101, the ROM 1102, and the RAM 1103 are connected to each other through a bus 1104. An input/output (I/O) interface 1105 is also connected to the bus 1104.

The following parts are connected to the I/O interface 1105: an input portion 1106 including a keyboard, a mouse, and the like; an output portion 1107 including a cathode ray tube (CRT), a liquid crystal display (LCD), a speaker, and the like; the storage portion 1108 including a hard disk, and the like; and a communication portion 1109 including a network interface card such as a local area network (LAN) card or a modem. The communication portion 1109 performs communication processing via a network such as the Internet. A driver 1110 is also connected to the I/O interface 1105 according to a requirement. A removable medium 1111 such as a magnetic disk, an optical disc, a magneto-optical disc, or a semiconductor memory is mounted on the driver 1110 according to a requirement, so that a computer program read from the removable medium is installed into the storage portion 1108 according to a requirement.

In particular, according to the embodiments of this application, a process described above with reference to the flowchart may be implemented as a computer software program. For example, embodiments of this application include a computer program product, where the computer program product includes a computer program carried on a computer-readable medium, and the computer program includes a computer program used to perform the method shown in the flowchart. In such an embodiment, the computer program may be downloaded and installed from a network through the communication portion 1109, and/or installed from the removable medium 1111. When the computer program is executed by the central processing unit (CPU) 1101, various functions defined in the system of this application are executed.

It should be noted that the computer-readable medium described in the embodiments of this application may be a computer-readable signal medium, a computer-readable storage medium, or any combination thereof. The computer-readable storage medium may be, for example, an electrical system, apparatus, or device, a magnetic system, apparatus, or device, an optical system, apparatus, or device, an electromagnetic system, apparatus, or device, an infrared system, apparatus, or device, or a semiconductor system, apparatus, or device, or any combination thereof. A more specific example of the computer-readable storage medium may include but is not limited to an electrical connection having one or more wires, a portable computer disk, a hard disk, a random access memory (RAM), a read-only memory (ROM), an erasable programmable read-only memory (Erasable Programmable Read Only Memory, EPROM), a flash memory, an optical fiber, a portable compact disk read-only memory (Compact Disc Read-Only Memory, CD-ROM), an optical storage device, a magnetic storage device, or any proper combination thereof. In this application, the computer-readable signal medium may include a data signal propagated in a baseband or as a part of a carrier, and carries a computer-readable computer program. The propagated data signal may be in a plurality of forms, including but not limited to an electromagnetic signal, an optical signal, or any suitable combination thereof. The computer-readable signal medium may alternatively be any computer-readable medium other than a computer-readable storage medium, and the computer-readable medium may send, propagate, or transmit a program used by or in combination with an instruction execution system, apparatus, or device. The computer program included in the computer-readable medium may be transmitted by using any proper medium, including but not limited to a wireless medium or a wired medium, or any proper combination thereof.

The flowcharts and block diagrams in the accompanying drawings show system architectures, functions, and operations that may be implemented by systems, methods, and computer program products according to various embodiments of this application. Each block in the flowcharts or block diagrams may represent a module, a program segment, or a part of code, and the module, the program segment, or the part of code includes one or more executable instructions for implementing a specified logical function. It should also be noted that, in some alternative implementations, a function marked in the block may also occur in a sequence different from that marked in the accompanying drawings. For example, two consecutively represented blocks may be actually executed substantially in parallel, and may sometimes be executed in a reverse order, depending on a function involved. It should also be noted that each block in the block diagrams or the flowcharts and a combination of blocks in the block diagrams or the flowcharts may be implemented by using a dedicated hardware-based system designed to perform a specified function or operation, or may be implemented by using a combination of dedicated hardware and computer instructions.

The units involved in the embodiments of this application may be implemented by using software, or may be implemented by using hardware, and the units described may also be disposed in a processor. Names of these units do not constitute a limitation on the units in a specified case.

Another aspect of this application further provides a computer-readable storage medium, and a computer program is stored on the computer-readable storage medium. When the computer program is executed by a processor of a computer, the computer is enabled to perform the foregoing method for calculating an internal resistance of a lithium-ion battery. The computer-readable storage medium may be included in the electronic device described in the foregoing embodiment, or may exist separately, and is not assembled into the electronic device.

Another aspect of this application further provides a computer program product or a computer program. The computer program product or the computer program includes computer instructions, and the computer instructions are stored in a computer-readable storage medium. The processor of the computer device reads the computer instruction from the computer-readable storage medium, and the processor executes the computer instruction, so that the computer device executes the method for calculating an internal resistance of a lithium-ion battery provided in the foregoing embodiments.

The foregoing embodiments merely illustrate principles and effects of the present invention, but are not intended to limit the present invention. Any person skilled in the art may modify or alter the foregoing embodiments without departing from the scope of the present invention. Therefore, all equivalent modifications or alterations completed by a person of ordinary skill in the art without departing from the essence and technical ideas disclosed in the present invention should still be covered by the claims of the present invention.

**Claims**

1.  A method for calculating an internal resistance of a lithium-ion battery, comprising:

    obtaining battery working parameters, wherein the battery working parameters comprise a temperature, a charging/discharging current, a concentration difference potential, a lithium-ion concentration as a function of time, and a state of charge of a lithium-ion battery as a function of ohmic internal resistance and temperature;

    decomposing an internal resistance of a to-be-calculated battery into a charge transfer internal resistance, a mass transfer internal resistance, and an ohmic internal resistance;

    calculating the charge transfer internal resistance based on the temperature and the charging/discharging current, calculating the mass transfer internal resistance based on a first function of the lithium-ion concentration over time, the charging/discharging current, and the concentration difference potential, and calculating the ohmic internal resistance based on a function of the state of charge of the lithium-ion battery over ohmic internal resistance and temperature; and

    combining the mass transfer internal resistance, the charge transfer internal resistance, and the ohmic internal resistance to obtain the internal resistance of the to-be-calculated battery.

2.  The method for calculating an internal resistance of a lithium-ion battery according to claim 1, wherein calculating the charge transfer internal resistance based on the temperature and the charging/discharging current comprises: obtaining the charge transfer internal resistance by using a gas constant, a Faraday constant, the temperature, and the charging/discharging current.

3.  The method for calculating an internal resistance of a lithium-ion battery according to claim 1, wherein calculating the mass transfer internal resistance based on the function of the lithium-ion concentration over time and the concentration difference potential, the concentration difference potential comprising a negative electrode concentration difference potential, a positive electrode concentration difference potential, and an electrolyte concentration difference potential, comprises:

    obtaining the negative electrode concentration difference potential by using a temperature and a negative electrode state of charge of the lithium-ion battery;

    obtaining the positive electrode concentration difference potential by using a temperature and a positive electrode state of charge of the lithium-ion battery;

    obtaining the electrolyte concentration difference potential by using a quantity of migrated lithium ions, a concentration of lithium ions at an electrolyte layer on a surface of a positive electrode of the battery, a concentration of lithium ions at an electrolyte layer on a surface of a negative electrode of the battery, a temperature, and the first function of the lithium-ion concentration over time; and

    obtaining the mass transfer internal resistance based on the positive electrode concentration difference potential, the negative electrode concentration difference potential, the electrolyte concentration difference potential, and the charging/discharging current.

4.  The method for calculating an internal resistance of a lithium-ion battery according to claim 3, wherein obtaining the negative electrode concentration difference potential by using the gas constant, the Faraday constant, the temperature, and the negative electrode state of charge of the lithium-ion battery comprises:

    obtaining the negative electrode concentration difference potential according to the following formula:

$$\eta_{mt}^{-} = -\frac{RT}{F}\ln(\frac{1-x_1}{x_1})$$

wherein $\eta_{mt}^{-}$ is the concentration difference potential in a lithium-ion transmission process at the negative electrode, F is the Faraday constant, R is the gas constant, T is the temperature, and $x_1$ is the negative electrode state of charge.

5. The method for calculating an internal resistance of a lithium-ion battery according to claim 3, wherein obtaining the positive electrode concentration difference potential by using the gas constant, the Faraday constant, the temperature, and the positive electrode state of charge of the lithium-ion battery comprises:

obtaining the positive electrode concentration difference potential according to the following formula:

$$\eta_{mt}^{+} = -\frac{RT}{F}\ln(\frac{1-x_2}{x_2})$$

wherein $\eta_{mt}^{+}$ is the concentration difference potential in a lithium-ion transmission process at the positive electrode, F is the Faraday constant, R is the gas constant, T is the ambient temperature, and $x_2$ is the positive electrode state of charge.

6. The method for calculating an internal resistance of a lithium-ion battery according to claim 3, wherein obtaining the electrolyte concentration difference potential by using the quantity of migrated lithium ions, the concentration of lithium ions at the electrolyte layer on the surface of the positive electrode of the battery, the concentration of lithium ions at the electrolyte layer on the surface of the negative electrode of the battery, the temperature, and the first function of the lithium-ion concentration over time comprises:

obtaining an initial electrolyte concentration difference potential by using the quantity of migrated lithium ions, the concentration of the lithium ions at the electrolyte layer on the surface of the positive electrode of the battery, the concentration of the lithium ions at the electrolyte layer on the surface of the negative electrode of the battery, a Faraday constant, a gas constant, and the temperature:

$$\eta_{mt}^{e} - \frac{2t_{+}RT}{F}\ln\left(\frac{C_{Li}^{ca}}{C_{Li}^{an}}\right)$$

wherein $\eta_{mt}^{e}$ is the initial electrolyte concentration difference potential, $t_{+}$ is the quantity of migrated lithium ions, $C_{Li}^{ca}$ is the concentration of the lithium ions at the electrolyte layer on the surface of the positive electrode, $C_{Li}^{an}$ is the concentration of the lithium ions at the electrolyte layer on the surface of the negative electrode, F is the Faraday constant, R is the gas constant, and T is the temperature; and

obtaining the electrolyte concentration difference potential $\eta_{mt}^{E}$ based on the first function of the lithium-ion concentration over time and the initial electrolyte concentration difference potential:

$$\eta_{mt}^{E} = f_{e}(T, t_0)$$

wherein $\eta_{mt}^{E}$ is the electrolyte concentration difference potential, T is the temperature, and $t_0$ is a battery aging time.

7. The method for calculating an internal resistance of a lithium-ion battery according to any one of claims 4, 5, or 6, wherein obtaining the mass transfer internal resistance based on the positive electrode concentration difference potential, the negative electrode concentration difference potential, the electrolyte concentration difference potential, and the charging/discharging current comprises:

summing the positive electrode concentration difference potential, the negative electrode concentration difference potential, and the electrolyte concentration difference potential to obtain a first total concentration difference potential; and

determining a ratio of the first total concentration difference potential to the charging/discharging current as the mass transfer internal resistance.

8. The method for calculating an internal resistance of a lithium-ion battery according to claim 1, wherein calculating the ohmic internal resistance based on the function of the state of charge of the lithium-ion battery over ohmic internal resistance and temperature comprises:

setting first test parameters, wherein the first test parameters comprise the state of charge, the temperature, and a preset frequency range of the lithium-ion battery, and there are a plurality of groups of first test parameters;

testing AC impedance under the first test parameters to obtain a plurality of groups of AC impedance test results;

recording the AC impedance test results as Nyquist plots to obtain a plurality of Nyquist plots, and obtaining an intercept of a horizontal axis of a high frequency band in the Nyquist plot by using a linear difference method;

recording the intercept of the Nyquist plot as an ohmic internal resistance under a corresponding test parameter, to obtain a plurality of reference ohmic internal resistances, and outputting a two-dimensional numerical table of the reference ohmic internal resistances;

fitting a reference ohmic internal resistance in the two-dimensional numerical table of the reference ohmic internal resistances based on a function between an ohmic internal resistance and a temperature and a state of charge of a lithium-ion battery, to obtain an ohmic internal resistance fitting coefficient; and

substituting the ohmic internal resistance fitting coefficient into the function between an ohmic internal resistance and a temperature and a state of charge of a lithium-ion battery, to obtain an ohmic internal resistance.

9. The method for calculating an internal resistance of a lithium-ion battery according to claim 6, wherein combining the mass transfer internal resistance, the charge transfer internal resistance, and the ohmic internal resistance to obtain the internal resistance of the to-be-calculated battery further comprises:

calculating a life-cycle mass transfer internal resistance and a life-cycle ohmic internal resistance; and

summing the charge transfer internal resistance, the life-cycle mass transfer internal resistance, and the life-cycle ohmic internal resistance to obtain a life-cycle internal resistance of the to-be-calculated battery.

10. The method for calculating an internal resistance of a lithium-ion battery according to claim 9, wherein the calculating a life-cycle mass transfer internal resistance comprises:

obtaining a life-cycle electrolyte concentration difference potential $\eta_{\mathrm{mt}}^{h}$ based on the initial electrolyte concentration difference potential and a second function of the lithium-ion concentration over time:

$$\eta_{\mathrm{mt}}^{\mathrm{h}} = f_{\mathrm{e}}(T, t_0, x, I)$$

wherein $\eta_{\mathrm{mt}}^{h}$ is the life-cycle electrolyte concentration difference potential, $t_0$ is the battery aging time, T is the ambient temperature, x is the state of charge of the lithium-ion battery, and I is the charging/discharging current;

summing the positive electrode concentration difference potential, the negative electrode concentration difference potential, and the life-cycle electrolyte concentration difference potential to obtain a second total concentration difference potential; and

determining a ratio of the second total concentration difference potential to the charging/discharging current as the life-cycle mass transfer internal resistance.

11. The method for calculating an internal resistance of a lithium-ion battery according to claim 9, wherein calculating a life-cycle ohmic internal resistance comprises:

obtaining an initial ohmic internal resistance of the lithium-ion battery by using a function between an ohmic internal resistance and a state of charge of the lithium-ion battery and a temperature;
obtaining a function between the ohmic internal resistance and aging of the lithium-ion battery according to the initial ohmic internal resistance and a relationship between a thickness of a solid-state electrolyte membrane and aging of the lithium-ion battery:

$$f_\Omega(t) = R_\Omega^{re}(1 + \beta \ln(1 + \theta t_0))$$

wherein $R_\Omega^{re}$ represents the initial ohmic internal resistance of the lithium-ion battery in an initial state, $\beta$ and $\theta$ are constants, and $t_0$ is a battery aging time; and
obtaining the life-cycle ohmic internal resistance according to the function between an ohmic internal resistance and a state of charge of the lithium-ion battery and an ambient temperature and the function between the ohmic internal resistance and the aging of the lithium-ion battery:

$$R_\Omega^h = R_\Omega^0(1 + ax + bT + cxT)(1 + \beta \ln(1 + \theta t_0))$$

wherein $R_\Omega^h$ is the life-cycle ohmic internal resistance, $R_\Omega^0$ is an ohmic internal resistance at a reference temperature, $T$ is a temperature, $x$ is the state of charge of the battery, $t_0$ is the battery aging time, a, b, and c are to-be-fitted coefficients, and $\beta$ and $\theta$ are constants.

12. An apparatus for calculating an internal resistance of a lithium-ion battery, comprising:

an obtaining module, configured to obtain a function between a lithium-ion concentration and a time, and obtain a life-cycle ohmic internal resistance;
a decomposition module, configured to decompose an internal resistance of a to-be-calculated battery into a charge transfer internal resistance, a mass transfer internal resistance, and an ohmic internal resistance;
a calculation module, configured to: calculate the charge transfer internal resistance based on the temperature and a charging/discharging current, calculate the mass transfer internal resistance based on the function between the lithium-ion concentration and the time, the charging/discharging current, and the concentration difference potential, and calculate the ohmic internal resistance based on the function between the state of charge of the lithium-ion battery and the temperature and the ohmic internal resistance; and
a combination module, configured to combine the mass transfer internal resistance, the charge transfer internal resistance, and the ohmic internal resistance to obtain the internal resistance of the to-be-calculated battery.

13. An electronic device, comprising:

one or more processors;
a storage apparatus, configured to store one or more programs, wherein when the one or more programs are executed by the one or more processors, the electronic device is enabled to implement the method for calculating an internal resistance of a lithium-ion battery according to any one of claims 1 to 11.

14. A computer-readable storage medium, wherein the computer-readable storage medium stores a computer program, and when the computer program is executed by a processor of a computer, the computer is enabled to perform the method for calculating an internal resistance of a lithium-ion battery according to any one of claims 1 to 11.

Obtain battery working parameters

S110

Decompose an internal resistance of a to-be-calculated battery into a charge transfer internal resistance, a mass transfer internal resistance, and an ohmic internal resistance

S120

Calculate the charge transfer internal resistance based on a temperature and a charging/discharging current, calculate the mass transfer internal resistance based on a first function between a lithium-ion concentration and a time, the charging/discharging current, and a concentration difference potential, and calculate the ohmic internal resistance based on a function between a state of charge of a lithium-ion battery and a temperature and an ohmic internal resistance

S130

Combine the mass transfer internal resistance, the charge transfer internal resistance, and the ohmic internal resistance to obtain the internal resistance of the to-be-calculated battery

S140

FIG. 1

Obtain a negative electrode concentration difference potential by using a temperature and a negative electrode state of charge of the lithium-ion battery

S210

Obtain a positive electrode concentration difference potential by using a temperature and a positive electrode state of charge of the lithium-ion battery

S220

Obtain an electrolyte concentration difference potential by using a quantity of migrated lithium ions, a concentration of lithium ions on a surface of a positive electrode of the battery, a concentration of lithium ions on a surface of a negative electrode of the battery, a temperature, and a first function between a lithium-ion concentration and a time

S230

Obtain a mass transfer internal resistance based on the positive electrode concentration difference potential, the negative electrode concentration difference potential, the electrolyte concentration difference potential, and a charging/discharging current

S240

FIG. 2

FIG. 3

Set first test parameters, where the first test parameters include a plurality of groups — S410

↓

Test AC impedance under the first test parameters to obtain a plurality of groups of AC impedance test results — S420

↓

Record the AC impedance test results as Nyquist plots to obtain a plurality of Nyquist plots, and obtain an intercept of a horizontal axis of a high frequency band in the Nyquist plot by using a linear difference method — S430

↓

Fit a reference ohmic internal resistance in a two-dimensional numerical table of reference ohmic internal resistances based on a function relationship between an ohmic internal resistance and a temperature and a state of charge of a lithium-ion battery, to obtain an ohmic internal resistance fitting coefficient — S440

↓

Substitute the ohmic internal resistance fitting coefficient into the function relationship between an ohmic internal resistance and a temperature and a state of charge of a lithium-ion battery, to obtain an ohmic internal resistance — S450

FIG. 4

| Calculate a life-cycle mass transfer internal resistance and a life-cycle ohmic internal resistance | S510 |

| Sum a charge transfer internal resistance, the life-cycle mass transfer internal resistance, and the life-cycle ohmic internal resistance to obtain a life-cycle internal resistance of a to-be-calculated battery | S520 |

FIG. 5

| Set a plurality of groups of second test parameters | S610 |

| Perform cyclic voltammetry testing and AC impedance testing on a battery under the second test parameters every preset aging time, and repeat the action within preset cycles | S620 |

| Compile a diffusion coefficient obtained through testing into a matrix table to obtain a life-cycle diffusion coefficient, and compile an ohmic resistance obtained through testing into a matrix table to obtain a life-cycle ohmic internal resistance | S630 |

FIG. 6

FIG. 7a

FIG. 7b

FIG. 7c

FIG. 8a

FIG. 8b

FIG. 8c

FIG. 9a

FIG. 9b

FIG. 9c

Apparatus for calculating an
internal resistance of a
lithium-ion battery — 1000

1010

Obtaining module

1020

Decomposition module

1030

Calculation module

1040

Combination module

1050

Battery life-cycle internal
resistance calculation
module

FIG. 10

1100

1101

CPU

1102

ROM

1103

RAM

1104

1105

I/O interface

1106

Input portion

1107

Output portion

1108

Storage portion

1109

Communication portion

1110

Driver

1111

Removable medium

FIG. 11

| A. | CLASSIFICATION OF SUBJECT MATTER |
|---|---|

G01R 31/389(2019.01)i

According to International Patent Classification (IPC) or to both national classification and IPC

| B. | FIELDS SEARCHED |
|---|---|

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNTXT; CNKI; ENTXTC; ENTXT; VEN: 锂电池, 内阻, 阻抗, 电阻, 欧姆, 传质, 浓差, 扩散, 传荷, 电荷转移, 反应, 温度, 电流, 荷电状态, SOC, 充电状态, 浓差, 浓度, 时间, 电势, 电位, 电压, 全周期, 正极, 负极, battery, internal, impedance, resistance, mass transfer, charge transfer, ohm, diffusion, temperature, current, state of charge, concentration, potential

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 116699420 A (DEEPAL AUTOMOBILE TECHNOLOGY CO., LTD.) 05 September 2023 (2023-09-05) <br> claims 1-14 | 1-14 |
| Y | CN 110501655 A (LENOVO (BEIJING) CO., LTD.) 26 November 2019 (2019-11-26) <br> claims 5, 9, and 10 | 1-2, 8, 12-14 |
| Y | US 2020072909 A1 (TOYOTA MOTOR CO., LTD.) 05 March 2020 (2020-03-05) <br> description, paragraphs 53-60 | 1-2, 8, 12-14 |
| Y | CN 107045109 A (BEIJING ELECTRIC VEHICLE CO., LTD.) 15 August 2017 (2017-08-15) <br> claims 1-4 | 1-2, 8, 12-14 |
| A | CN 106872905 A (HARBIN INSTITUTE OF TECHNOLOGY) 20 June 2017 (2017-06-20) <br> entire document | 1-14 |
| A | CN 108919137 A (TONGJI UNIVERSITY) 30 November 2018 (2018-11-30) <br> entire document | 1-14 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **22 February 2024** | **24 February 2024** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |

**C.      DOCUMENTS CONSIDERED TO BE RELEVANT**

| Category* | Citation of document, with indication, where appropriate, of the relevant passages | Relevant to claim No. |
|---|---|---|
| A | CN 112180278 A (TIANJIN UNIVERSITY) 05 January 2021 (2021-01-05)<br>entire document | 1-14 |
| A | CN 112582650 A (CHINA JILIANG UNIVERSITY) 30 March 2021 (2021-03-30)<br>entire document | 1-14 |
| A | US 2018006335 A1 (TOSHIBA K.K.) 04 January 2018 (2018-01-04)<br>entire document | 1-14 |
| A | US 2019128969 A1 (MICROVAST POWER SYSTEMS CO., LTD.) 02 May 2019 (2019-05-02)<br>entire document | 1-14 |

| Patent document cited in search report | | | Publication date (day/month/year) | Patent family member(s) | | | Publication date (day/month/year) |
|---|---|---|---|---|---|---|---|
| CN | 116699420 | A | 05 September 2023 | None | | | |
| CN | 110501655 | A | 26 November 2019 | None | | | |
| US | 2020072909 | A1 | 05 March 2020 | KR | 20200026739 | A | 11 March 2020 |
| | | | | KR | 102292469 | B1 | 25 August 2021 |
| | | | | JP | 2020034426 | A | 05 March 2020 |
| | | | | JP | 6973334 | B2 | 24 November 2021 |
| | | | | EP | 3617726 | A1 | 04 March 2020 |
| | | | | EP | 3617726 | B1 | 09 September 2020 |
| | | | | US | 11009556 | B2 | 18 May 2021 |
| CN | 107045109 | A | 15 August 2017 | None | | | |
| CN | 106872905 | A | 20 June 2017 | None | | | |
| CN | 108919137 | A | 30 November 2018 | None | | | |
| CN | 112180278 | A | 05 January 2021 | None | | | |
| CN | 112582650 | A | 30 March 2021 | None | | | |
| US | 2018006335 | A1 | 04 January 2018 | JPWO | 2017046870 | A1 | 07 December 2017 |
| | | | | JP | 6383500 | B2 | 29 August 2018 |
| | | | | WO | 2017046870 | A1 | 23 March 2017 |
| | | | | EP | 3352287 | A1 | 25 July 2018 |
| | | | | US | 10644359 | B2 | 05 May 2020 |
| US | 2019128969 | A1 | 02 May 2019 | US | 10921380 | B2 | 16 February 2021 |
| | | | | EP | 3480613 | A1 | 08 May 2019 |
| | | | | EP | 3480613 | B1 | 06 September 2023 |

**REFERENCES CITED IN THE DESCRIPTION**

**Patent documents cited in the description**

- CN 111999667 A

- CN 113109726 A